(19) Europäisches Patentamt
European Patent Office
Office européen des brevets

(11) EP 4 234 562 B1

(12) # EUROPEAN PATENT SPECIFICATION

(45) Date of publication and mention of the grant of the patent:
**09.04.2025 Bulletin 2025/15**

(21) Application number: **21882731.9**

(22) Date of filing: **15.10.2021**

(51) International Patent Classification (IPC):
***C09K 11/06*** *(2006.01)* ***C07F 5/02*** *(2006.01)*
***H10K 85/60*** *(2023.01)* *H10K 50/11* *(2023.01)*

(52) Cooperative Patent Classification (CPC):
**C07F 5/027; C09K 11/06; H10K 85/636; H10K 85/657; H10K 85/658;** H10K 50/11

(86) International application number:
**PCT/JP2021/038271**

(87) International publication number:
**WO 2022/085590 (28.04.2022 Gazette 2022/17)**

(54) **LIGHT-EMITTING MATERIAL, AND ORGANIC ELECTROLUMINESCENT ELEMENT**
LICHTEMITTIERENDES MATERIAL UND ORGANISCHES ELEKTROLUMINESZENZELEMENT
MATÉRIAU ÉLECTROLUMINESCENT ET ÉLÉMENT ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.10.2020 JP 2020176205**

(43) Date of publication of application:
**30.08.2023 Bulletin 2023/35**

(73) Proprietors:
- **NIPPON STEEL Chemical & Material Co., Ltd.**
  **Tokyo 103-0027 (JP)**
- **Kyushu University, National University Corporation**
  **Nishi-ku**
  **Fukuoka-shi**
  **Fukuoka 819-0395 (JP)**

(72) Inventors:
- **TADA Masashi**
  **Tokyo 103-0027 (JP)**
- **KAWADA Atsushi**
  **Tokyo 103-0027 (JP)**
- **SAGARA Yuta**
  **Tokyo 103-0027 (JP)**
- **KITERA Sayuri**
  **Tokyo 103-0027 (JP)**
- **YASUDA Takuma**
  **Fukuoka-shi, Fukuoka 819-0395 (JP)**
- **MIN Hyukgi**
  **Fukuoka-shi, Fukuoka 819-0395 (JP)**
- **PARK In Seob**
  **Fukuoka-shi, Fukuoka 819-0395 (JP)**

(74) Representative: **Vossius & Partner**
**Patentanwälte Rechtsanwälte mbB**
**Siebertstraße 3**
**81675 München (DE)**

(56) References cited:
**CN-A- 111 153 919**
**CN-A- 112 480 154**
**CN-A- 113 173 943**
**JP-A- 2018 043 984**
**JP-A- 2020 002 120**
**JP-A- 2020 084 189**
**JP-A- 2020 132 636**
**JP-A- 2020 512 303**
**US-A1- 2020 161 552**
**US-A1- 2020 328 352**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Technical Field

The present invention relates to a light-emitting material and an organic electroluminescent device (also referred to as an organic EL device) including the light-emitting material as a light emitting layer.

When a voltage is applied to an organic EL device, holes and electrons are injected from the anode and the cathode, respectively, into the light emitting layer. Then, the injected holes and electrons are recombined in the light emitting layer to thereby generate excitons. At this time, according to the electron spin statistics theory, singlet excitons and triplet excitons are generated at a ratio of 1:3. In the fluorescent organic EL device that uses emission caused by singlet excitons, the limit of the internal quantum efficiency is said to be 25%. On the other hand, it has been known that, in the phosphorescent organic EL device that uses emission caused by triplet excitons, the internal quantum efficiency can be enhanced up to 100% when intersystem crossing efficiently occurs from singlet excitons.

A technology for extending the lifetime of a phosphorescent organic EL device has advanced in recent years, and the device is being applied to a display of a mobile phone and others. Regarding a blue organic EL device, however, a practical phosphorescent organic EL device has not been developed, and thus the development of a blue organic EL device having high efficiency and a long lifetime is desired.

Further, a highly efficient delayed fluorescence organic EL device utilizing delayed fluorescence has been developed, in recent years. For example, Patent Literature 1 discloses an organic EL device utilizing the Triplet-Triplet Fusion (TTF) mechanism, which is one of the mechanisms of delayed fluorescence. The TTF mechanism utilizes a phenomenon in which a singlet exciton is generated by the collision of two triplet excitons, and it is believed that the internal quantum efficiency can be enhanced up to 40%, in theory. However, its efficiency is low as compared with the efficiency of the phosphorescent organic EL device, and thus further improvement in efficiency is desired.

On the other hand, Patent Literature 2 discloses an organic EL device utilizing the Thermally Activated Delayed Fluorescence (TADF) mechanism. The TADF mechanism utilizes a phenomenon in which reverse intersystem crossing occurs from the triplet exciton to the singlet exciton in a material having a small energy difference between the singlet level and the triplet level, and it is believed that the internal quantum efficiency can be enhanced up to 100%, in theory. Specifically, Patent Literature 2 discloses an indolocarbazole compound as a thermally activated delayed fluorescence material.

Patent Literature 3-6 each disclose an emission material including a polycyclic aromatic compound containing a boron atom, and an organic EL device including the emission material.

### Citation List

### Patent Literature

Patent Literature 1: WO2010/134350
Patent Literature 2: WO2011/070963
Patent Literature 3: WO2015/102118
Patent Literature 4: WO2019/240080
Patent Literature 5: US2020/0066997
Patent Literature 6: US 2020/161552

### Summary of Invention

### Technical Problem

In view of applying an organic EL device to a display device such as a flat panel display and a light source, it is necessary to improve the emission efficiency of the device and sufficiently ensure the stability of the device at the time of driving, at the same time. The present invention has been made under such circumstances, and an object thereof is to provide an emission material that can be used to obtain a practically useful organic EL device having high emission efficiency and high driving stability, and an organic EL device including the emission material.

### Solution to Problem

Specifically, the present invention is an emission material represented by the following general formula (1), and

also an organic EL device comprising one or more light emitting layers between an anode and a cathode opposite to each other, wherein at least one of the light emitting layers contains the emission material.

[C1]

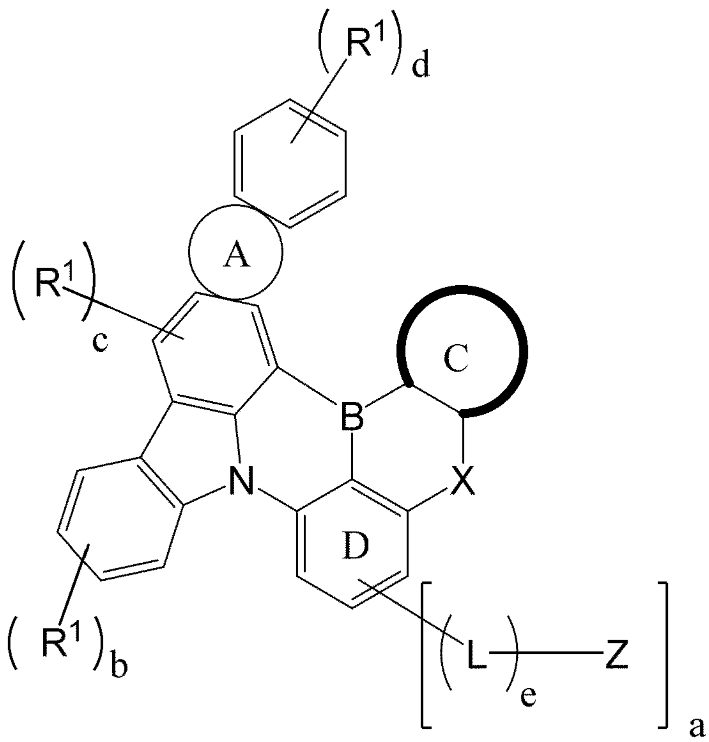

(1)

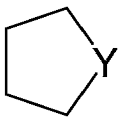

(1a)

In the formula, B represents a boron atom, a ring A represents a heterocycle fused with an adjacent ring at any position and represented by formula (1a), and a ring C represents a substituted or unsubstituted aromatic hydrocarbon ring having 6 to 30 carbon atoms, a substituted or unsubstituted aromatic heterocyclic ring having 2 to 30 carbon atoms, or a substituted or unsubstituted linked aromatic ring formed by linking 2 to 3 aromatic rings of aromatic groups selected from the aromatic hydrocarbon group and the aromatic heterocyclic group. A ring D represents a benzene ring.

X represents O, S, or N-$Ar^1$.

$Ar^1$ represents a substituted or unsubstituted aromatic hydrocarbon group having 6 to 30 carbon atoms, a substituted or unsubstituted aromatic heterocyclic group having 2 to 30 carbon atoms, or a substituted or unsubstituted linked aromatic group formed by linking 2 to 4 aromatic rings of aromatic groups selected from the aromatic hydrocarbon group and the aromatic heterocyclic group, and $Ar^1$ is optionally bonded with the ring C or the ring D by a single bond or a linked group to thereby form a ring.

Y represents O, S, or N-$Ar^2$.

$Ar^2$ represents a substituted or unsubstituted aromatic hydrocarbon group having 6 to 30 carbon atoms, a substituted or unsubstituted aromatic heterocyclic group having 2 to 30 carbon atoms, or a substituted or unsubstituted linked aromatic group formed by linking 2 to 4 aromatic rings of aromatic groups selected from the aromatic hydrocarbon group and the aromatic heterocyclic group.

Z independently represents a cyano group, deuterium, an aliphatic hydrocarbon group having 1 to 10 carbon atoms, a substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms; and when Z represents an aliphatic hydrocarbon group having 1 to 10 carbon atoms, a

substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms, Z is optionally bonded with the ring D by a single bond to thereby form a ring.

L represents O, S, or $C(R^2)_2$.

$R^2$ independently represents hydrogen, or an aliphatic group having 1 to 8 carbon atoms.
$R^1$ independently represents a cyano group, deuterium, an aliphatic hydrocarbon group having 1 to 10 carbon atoms, a substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms.
a represents an integer of 0 to 3, b and d each represent an integer of 0 to 4, and c and e represent 0 or 1.
In the general formula (1), X is preferably represented by $N\text{-}Ar^1$.
In the general formula (1a), Y is preferably represented by $N\text{-}Ar^2$,
**[0019]** In the general formula (1), the ring C is preferably represented by a substituted or unsubstituted benzene ring, or a substituted or unsubstituted aromatic heterocyclic ring having 2 to 30 carbon atoms.
The emission material represented by the general formula (1) is preferably represented by the following general formula (2).

[C2]

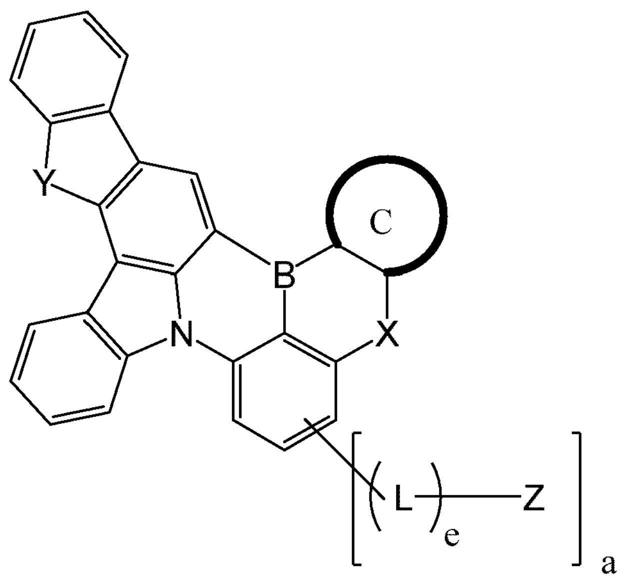

(2)

In the formula, ring C, X, Y, Z, L, a and e are the same as those defined in the general formula (1).
The present invention is an organic electroluminescent device comprising one or more light emitting layers between an anode and a cathode opposite to each other, wherein at least one of the light emitting layers contains the above emission material.
In the organic electroluminescent device of the present invention, the light emitting layer containing the emission material preferably contains a host material.
In the organic electroluminescent device of the present invention, the host material is more preferably a triazine compound or an anthracene compound.

Advantageous Effect of Invention

A practically useful organic EL device having high emission efficiency and high driving stability can be obtained by the emission material of the present invention.

Brief Description of Drawing

[Figure 1] Figure 1 shows a schematic cross-sectional view of a structure example of the organic EL device used

in the present invention.

Description of Embodiments

The organic EL device of the present invention has one or more light emitting layers between an anode and a cathode opposite to each other, and at least one layer of the light emitting layers contains the emission material represented by the general formula (1). The organic EL device has a plurality of layers between an anode and a cathode opposite to each other, at least one layer of the plurality of layers is a light emitting layer, and the light emitting layer may contain a host material, as necessary.

The general formula (1) will be described below.

First, B represents a boron atom, and a ring A represents a heterocycle fused with an adjacent ring at any position and represented by formula (1a).

A ring C represents a substituted or unsubstituted aromatic hydrocarbon ring having 6 to 30 carbon atoms, or a substituted or unsubstituted aromatic heterocyclic ring having 2 to 30 carbon atoms, or a substituted or unsubstituted linked aromatic ring formed by linking 2 to 3 aromatic rings of aromatic groups selected from the aromatic hydrocarbon ring group and the aromatic heterocyclic group. The ring C preferably represents a substituted or unsubstituted benzene ring, a substituted or unsubstituted aromatic heterocyclic ring having 2 to 30 carbon atoms, or a substituted or unsubstituted linked aromatic ring formed by linking 2 to 3 aromatic rings of aromatic groups selected from the aromatic hydrocarbon ring group and the aromatic heterocyclic group. The ring C more preferably represents a substituted or unsubstituted benzene ring, a substituted or unsubstituted aromatic heterocyclic ring having 2 to 20 carbon atoms, or a substituted or unsubstituted linked aromatic ring formed by linking 2 to 3 aromatic rings of aromatic groups selected from the aromatic hydrocarbon ring group and the aromatic heterocyclic group.

Specific examples of the unsubstituted ring C include benzene, naphthalene, acenaphthene, acenaphthylene, azulene, anthracene, chrysene, pyrene, phenanthrene, triphenylene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a linked aromatic ring in which 2 to 3 aromatic rings represented by these aromatic groups are linked. Preferred examples thereof include benzene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a linked aromatic ring in which 2 to 3 aromatic rings represented by these aromatic groups are linked. More preferred examples thereof include benzene, pyridine, pyrimidine, pyrazine, quinoline, isoquinoline, quinoxaline, quinazoline, indole, benzofuran, dibenzofuran, dibenzothiophene, carbazole, and a linked aromatic ring in which 2 to 3 aromatic rings represented by these aromatic groups are linked.

A ring D represents a benzene ring.

X represents O, S, or N-$Ar^1$, and preferably represents N-$Ar^1$.

Y represents O, S, or N-$Ar^2$, and preferably represents N-$Ar^2$,

$Ar^1$ and $Ar^2$ represent a substituted or unsubstituted aromatic hydrocarbon group having 6 to 30 carbon atoms, a substituted or unsubstituted aromatic heterocyclic group having 2 to 30 carbon atoms, or a substituted or unsubstituted linked aromatic group formed by linking 2 to 4 aromatic rings of aromatic groups selected from the aromatic hydrocarbon group and the aromatic heterocyclic group. These preferably represent a substituted or unsubstituted aromatic hydrocarbon group having 6 to 20 carbon atoms, a substituted or unsubstituted aromatic heterocyclic group having 2 to 20 carbon atoms, or a substituted or unsubstituted linked aromatic group formed by linking 2 to 3 aromatic rings of aromatic groups selected from the aromatic hydrocarbon group and the aromatic heterocyclic group. These more preferably represent a substituted or unsubstituted aromatic hydrocarbon group having 6 to 10 carbon atoms, a substituted or unsubstituted aromatic heterocyclic group having 2 to 10 carbon atoms, or a substituted or unsubstituted linked aromatic group formed by linking 2 to 3 aromatic rings of aromatic groups selected from the aromatic hydrocarbon group and the aromatic heterocyclic group.

$Ar^1$ can be bonded with the ring C or the ring D by a single bond or a linked group to thereby form a ring.

The linked group is preferably an ether group (-O-), a sulfide group (-S-), or a methylene group ($-C(R^2)_2-$). $R^2$ here independently represents hydrogen, or an aliphatic group having 1 to 8 carbon atoms, and specifically represents, for example, a methyl group, an ethyl group, a propyl group, a butyl group, a pentyl group, a hexyl group, a heptyl group, or an octyl group.

Specific examples of the unsubstituted $Ar^1$ and $Ar^2$ include a group produced by removing one hydrogen atom

from benzene, naphthalene, acenaphthene, acenaphthylene, azulene, anthracene, chrysene, pyrene, phenanthrene, triphenylene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a compound formed by linking 2 to 4 of these compounds. Preferred examples thereof include a group produced by removing one hydrogen atom from benzene, naphthalene, acenaphthene, acenaphthylene, azulene, anthracene, chrysene, pyrene, phenanthrene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a compound formed by linking 2 to 3 of these compounds. More preferred examples thereof include a group produced by removing one hydrogen atom from benzene, naphthalene, azulene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, and a compound formed by linking 2 to 3 of these compounds.

Herein, each of the aromatic hydrocarbon rings, aromatic heterocyclic groups, and linked aromatic rings, forming the ring C, and each of the aromatic hydrocarbon groups, aromatic heterocyclic groups, and linked aromatic groups, forming $Ar^1$ or $Ar^2$, may have a substituent. When these groups have a substituent, the substituent is a cyano group, an aliphatic hydrocarbon group having 1 to 10 carbon atoms, a diarylamino group having 12 to 30 carbon atoms, an alkoxy group having 1 to 10 carbon atoms, an aryloxy group having 6 to 18 carbon atoms, an alkylthio group having 1 to 10 carbon atoms, or an arylthio group having 6 to 18 carbon atoms. The number of substituents is 0 to 5, and preferably 0 to 2. When each of the aromatic hydrocarbon groups, aromatic hydrocarbon rings and aromatic heterocyclic groups, and the aromatic heterocyclic rings has a substituent, the number of carbon atoms of the substituent is not included in the calculation of the number of carbon atoms. However, it is preferred that the total number of carbon atoms including the number of carbon atoms of the substituent satisfy the above range.

Specific examples of the above substituent include cyano, methyl, ethyl, propyl, butyl, pentyl, hexyl, heptyl, octyl, nonyl, decyl, diphenylamino, naphthylphenylamino, dinaphthylamino, dianthranilamino, diphenanthrenylamino, methoxy, ethoxy, phenol, diphenyloxy, methylthio, ethylthio, thiophenol, and diphenylthio. Preferred examples thereof include cyano, methyl, ethyl, propyl, butyl, pentyl, hexyl, heptyl, octyl, diphenylamino, naphthylphenylamino, dinaphthylamino, phenol, and thiophenol.

Z independently represents a cyano group, deuterium, an aliphatic hydrocarbon group having 1 to 10 carbon atoms, a substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms. Z preferably represents a cyano group, deuterium, an aliphatic hydrocarbon group having 1 to 8 carbon atoms, a substituted or unsubstituted diarylamino group having 12 to 24 carbon atoms, a substituted or unsubstituted aromatic hydrocarbon group having 6 to 20 carbon atoms, or a substituted or unsubstituted aromatic heterocyclic group having 2 to 20 carbon atoms. Z more preferably represents a substituted or unsubstituted diarylamino group having 12 to 18 carbon atoms, a substituted or unsubstituted aromatic hydrocarbon group having 6 to 10 carbon atoms, or a substituted or unsubstituted aromatic heterocyclic group having 2 to 10 carbon atoms.

When Z represents an aliphatic hydrocarbon group having 1 to 10 carbon atoms, a substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms, Z is optionally bonded with the ring D by a single bond to thereby form a ring.

L represents O, S, or $C(R^2)_2$, and preferably represents O, or S.

$R^2$ here independently represents hydrogen, or an aliphatic group having 1 to 8 carbon atoms, and specifically represents, for example, a methyl group, an ethyl group, a propyl group, a butyl group, a pentyl group, a hexyl group, a heptyl group, or an octyl group.

When Z represents a diarylamino group or an aliphatic hydrocarbon group, specific examples of Z include diphenylamino, dibiphenylamino, phenylbiphenylamino, naphthylphenylamino, dinaphthylamino, dianthranilamino, diphenanthrenylamino, methyl, ethyl, propyl, butyl, pentyl, hexyl, heptyl, octyl, nonyl, and decyl. Preferred examples thereof include diphenylamino, dibiphenylamino, phenylbiphenylamino, naphthylphenylamino, dinaphthylamino, methyl, ethyl, propyl, butyl, pentyl, hexyl, heptyl, and octyl. More preferred examples thereof include diphenylamino and phenylbiphenylamino.

When Z represents an aromatic hydrocarbon group or an aromatic heterocyclic group, specific examples include

a group produced by removing one hydrogen atom from benzene, naphthalene, acenaphthene, acenaphthylene, azulene, anthracene, chrysene, pyrene, phenanthrene, triphenylene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, and carbazole. Preferred examples thereof include a group produced by removing one hydrogen atom from benzene, naphthalene, acenaphthene, acenaphthylene, azulene, anthracene, chrysene, pyrene, phenanthrene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, and carbazole. More preferred examples thereof include a group produced by removing one hydrogen atom from benzene, naphthalene, azulene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, and chromone.

$R^1$ independently represents a cyano group, deuterium, an aliphatic hydrocarbon group having 1 to 10 carbon atoms, a substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms. $R^1$ preferably represents a cyano group, deuterium, an aliphatic hydrocarbon group having 1 to 8 carbon atoms, a substituted or unsubstituted aromatic amino group having 12 to 24 carbon atoms, a substituted or unsubstituted aromatic hydrocarbon group having 6 to 20 carbon atoms, or a substituted or unsubstituted aromatic heterocyclic group having 2 to 20 carbon atoms. $R^1$ more preferably represents a substituted or unsubstituted diarylamino group having 12 to 18 carbon atoms, a substituted or unsubstituted aromatic hydrocarbon group having 6 to 10 carbon atoms, or a substituted or unsubstituted aromatic heterocyclic group having 2 to 10 carbon atoms.

a represents an integer of 0 to 3, preferably represents an integer of 0 to 1, and more preferably represents an integer of 0.
e represents an integer of 0 to 1, and preferably represents an integer of 0.
b and d each represent an integer of 0 to 4, preferably represent an integer of 0 to 1, and more preferably represent 0.
c represents 0 or 1, and preferably represents 0.

When $R^1$ is a diarylamino group or an aliphatic hydrocarbon group, specific examples of $R^1$ include diphenylamino, dibiphenylamino, phenylbiphenylamino, naphthylphenylamino, dinaphthylamino, dianthranilamino, diphenanthrenylamino, methyl, ethyl, propyl, butyl, pentyl, hexyl, heptyl, octyl, nonyl, and decyl. Preferred examples thereof include diphenylamino, dibiphenylamino, phenylbiphenylamino, naphthylphenylamino, dinaphthylamino, methyl, ethyl, propyl, butyl, pentyl, hexyl, heptyl, and octyl. More preferred examples thereof include diphenylamino and phenylbiphenylamino.

When $R^1$ is an aromatic hydrocarbon group or an aromatic heterocyclic group, specific examples of $R^1$ include a group produced by removing one hydrogen atom from benzene, naphthalene, acenaphthene, acenaphthylene, azulene, anthracene, chrysene, pyrene, phenanthrene, triphenylene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, and carbazole. Preferred examples thereof include a group produced by removing one hydrogen atom from benzene, naphthalene, acenaphthene, acenaphthylene, azulene, anthracene, chrysene, pyrene, phenanthrene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, and carbazole. More preferred examples thereof include a group produced by removing one hydrogen atom from benzene, naphthalene, azulene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, and chromone.

Specific examples of the emission materials represented by the general formula (1) are shown below, but the materials are not limited to these exemplified compounds.

[C3]

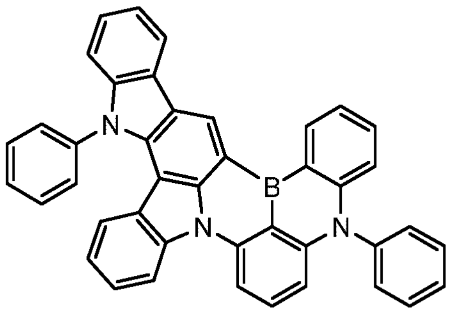

1

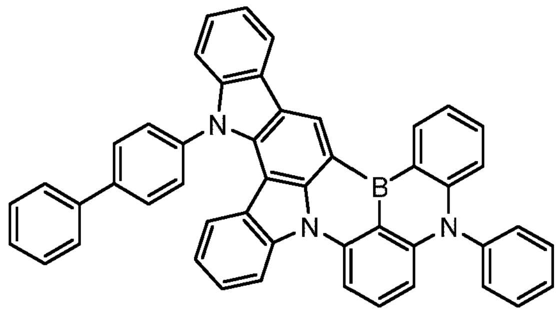

2

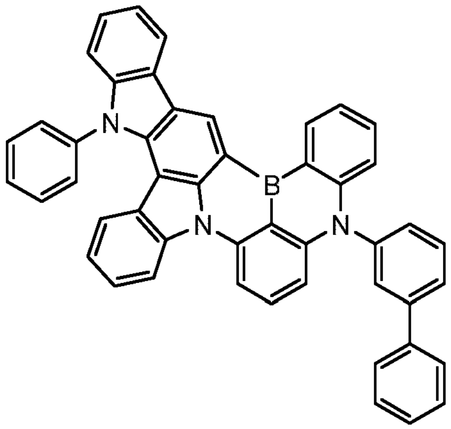

3

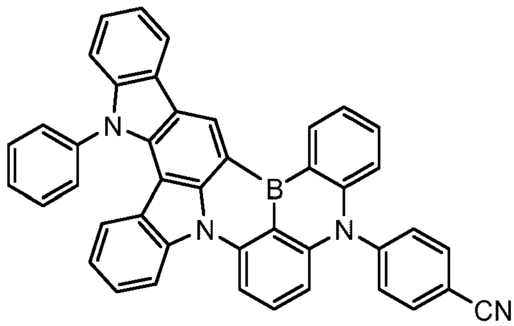

4

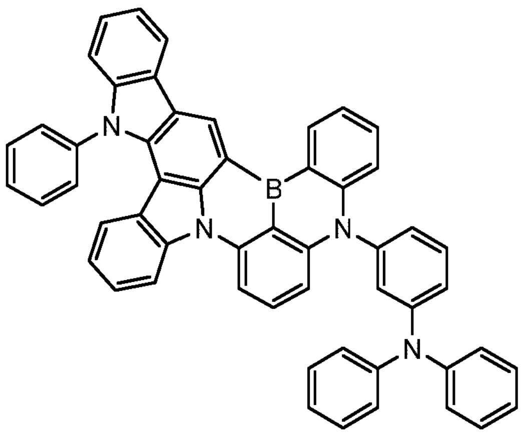

5

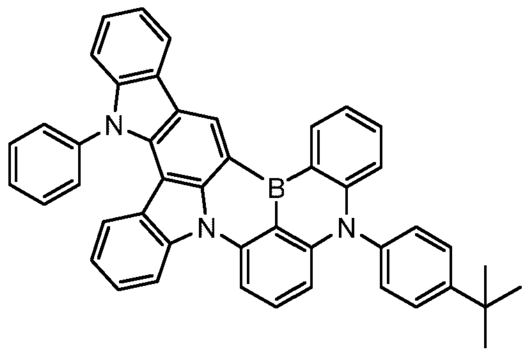

6

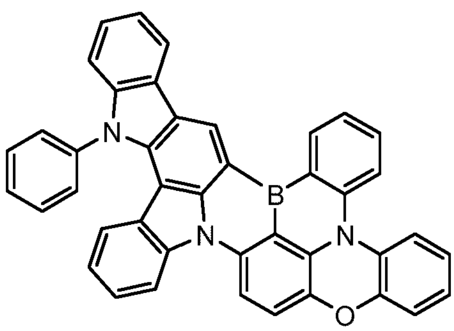

7

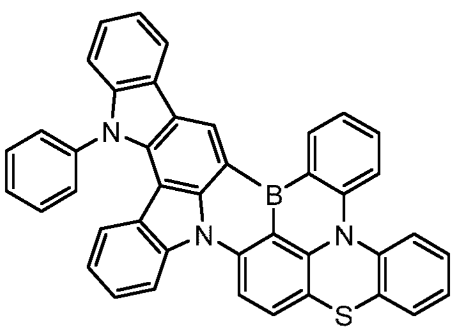

8

[C4]

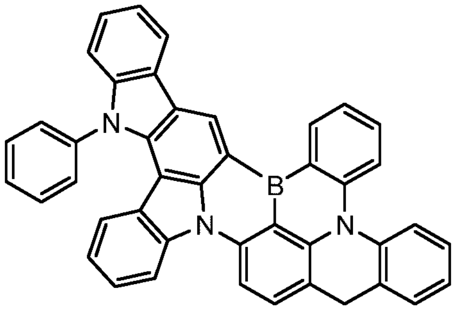

9

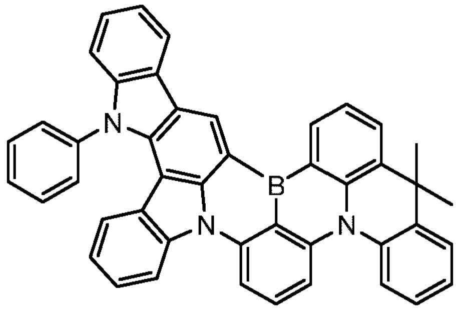

11

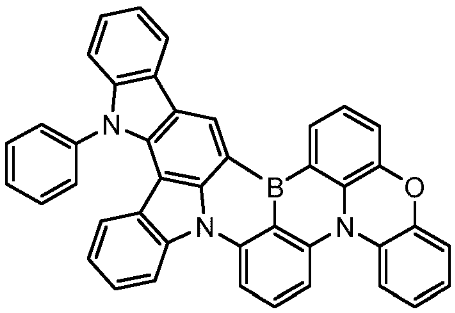

12

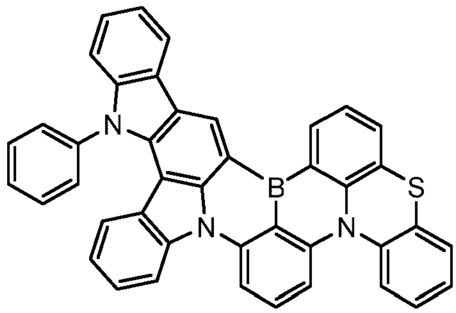

13

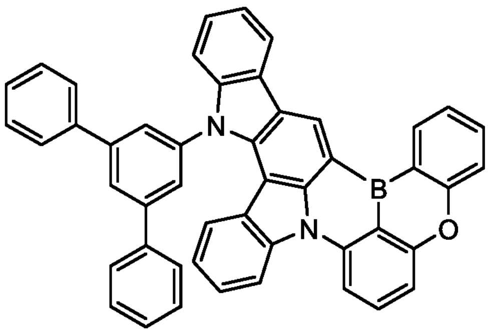

14

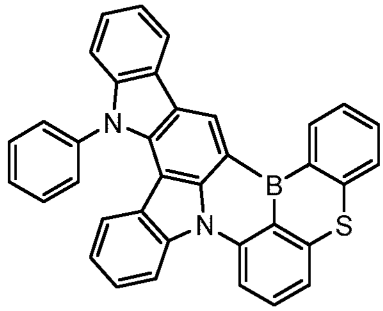

15

[C5]

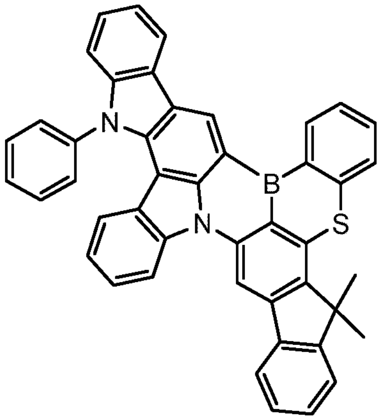

17

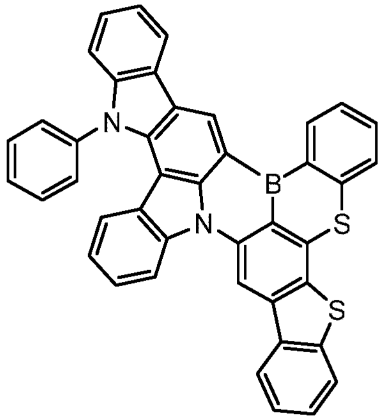

18

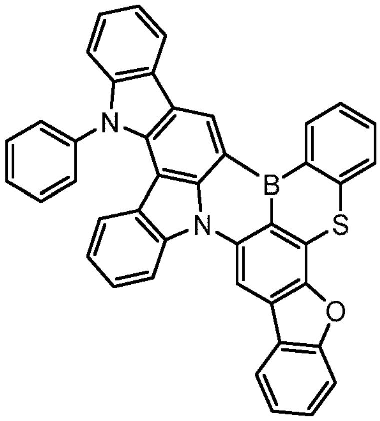

19

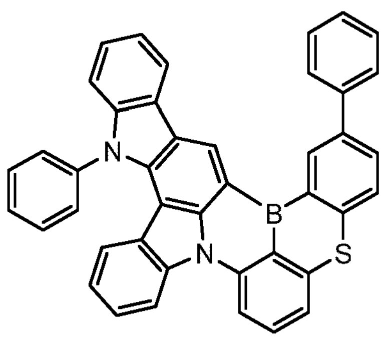

20

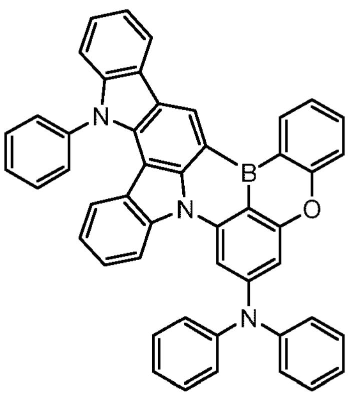

21

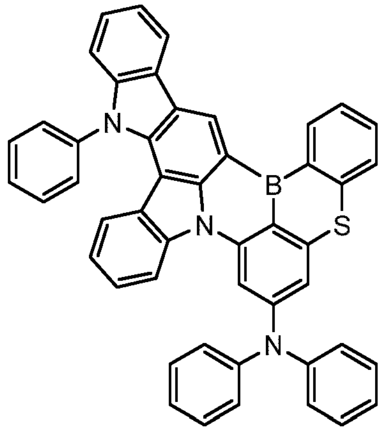

22

[C6]

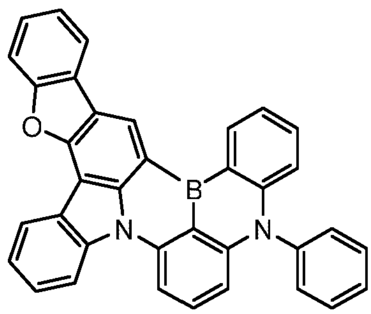

23

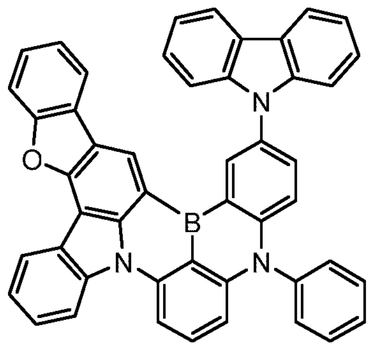

24

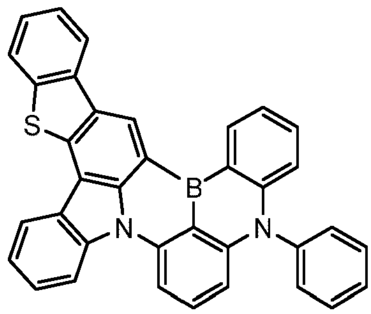

25

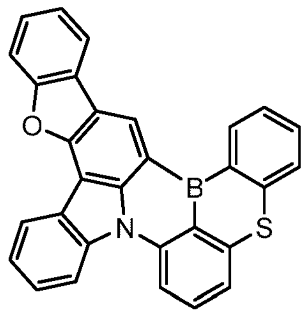

26

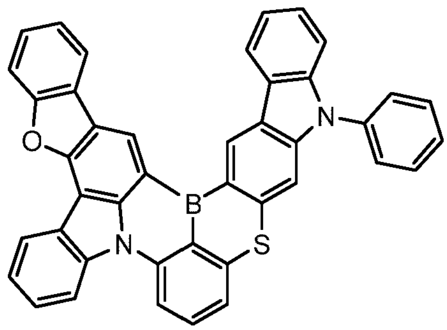

27

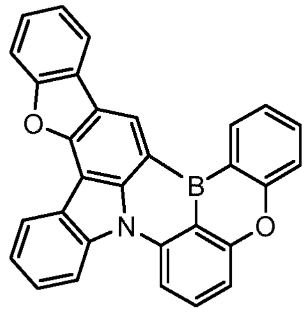

28

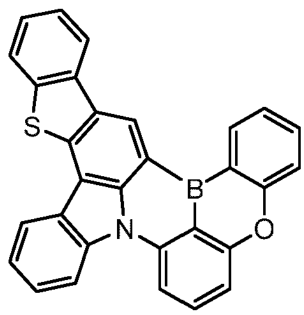

29

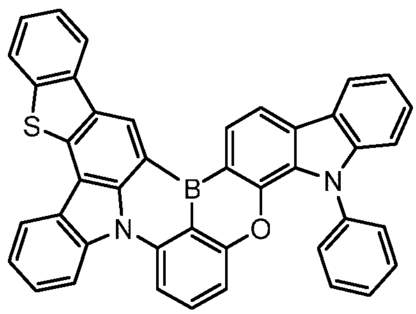

30

[C7]

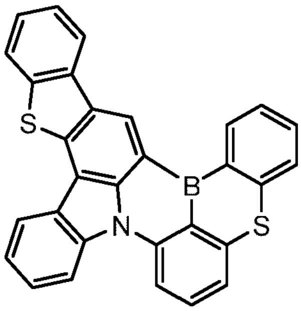

31

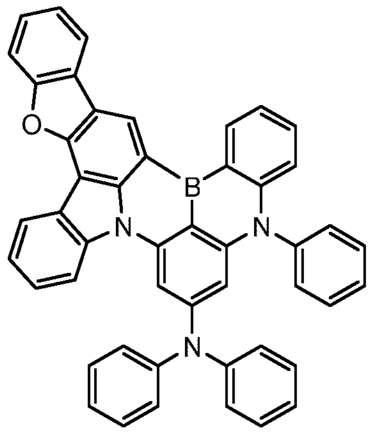

32

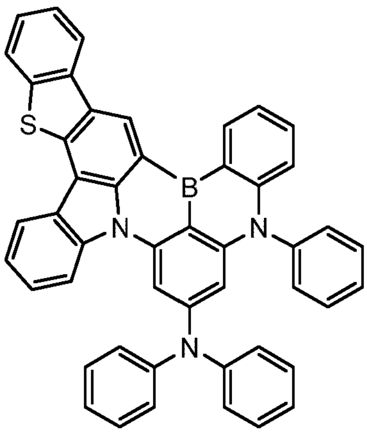

33

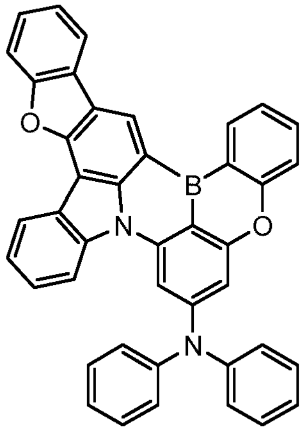

34

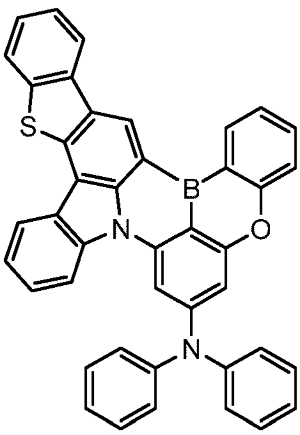

35

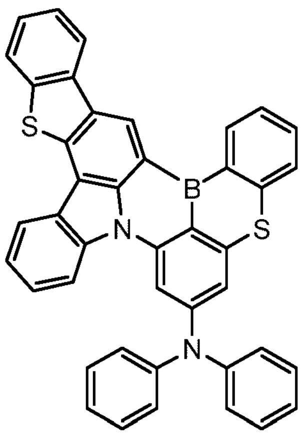

36

[C8]

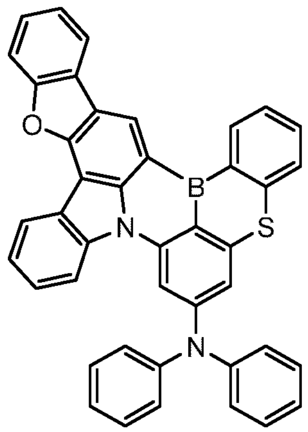

37

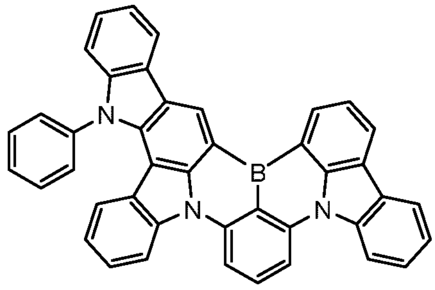

38

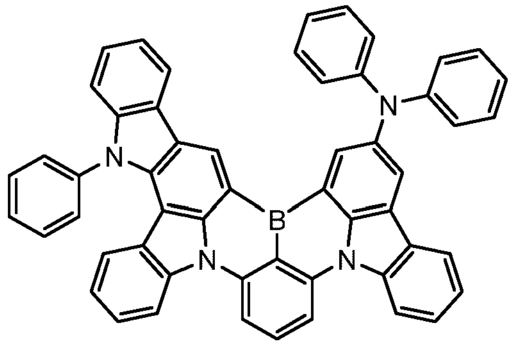

39

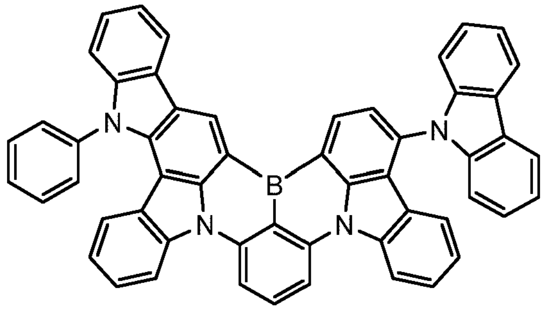

40

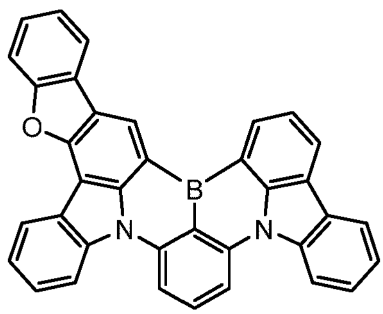

41

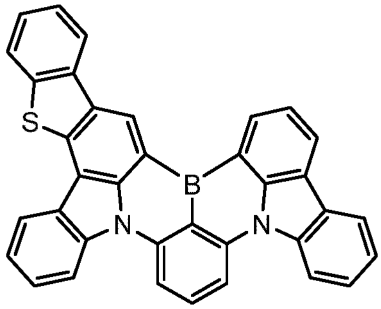

42

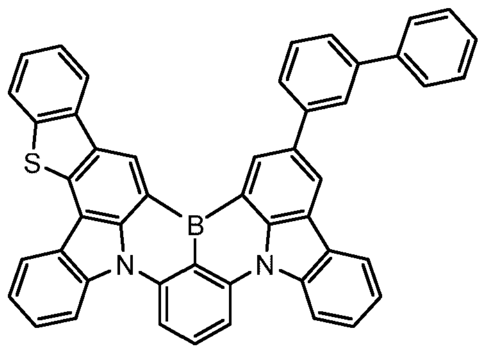

43

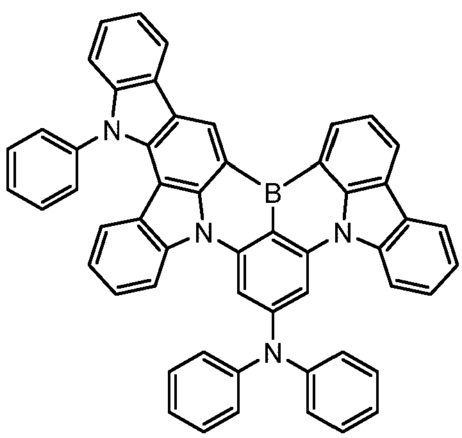

44

[C9]

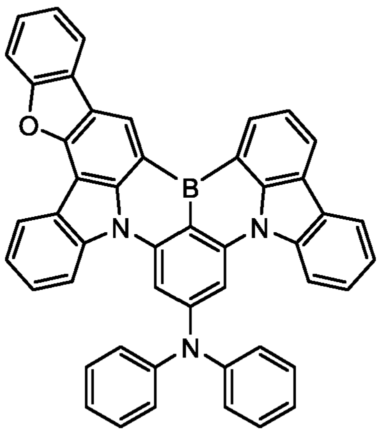
45

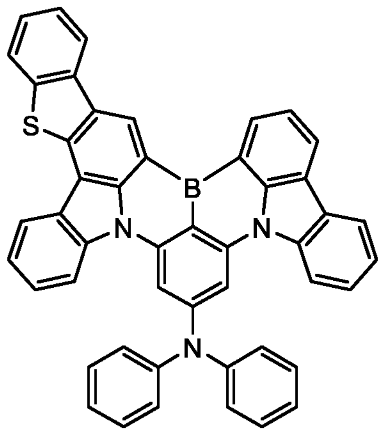
46

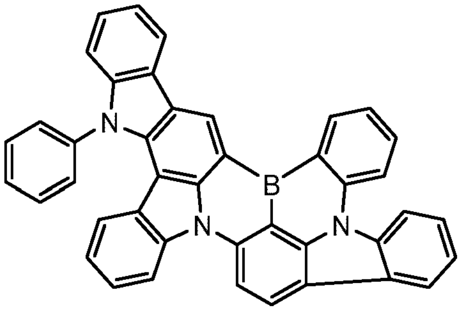
47

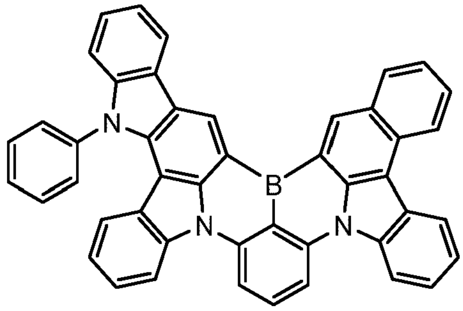
48

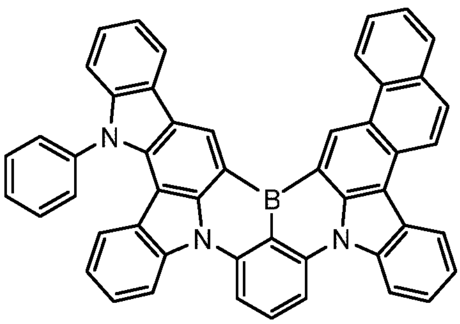
49

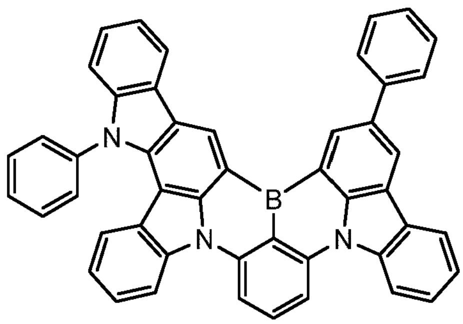
50

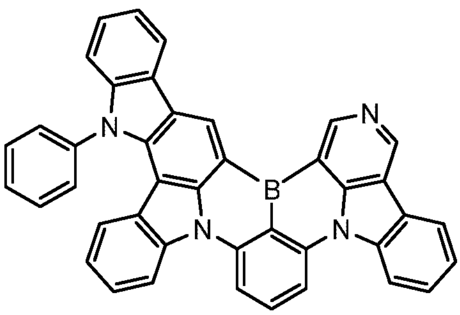
51

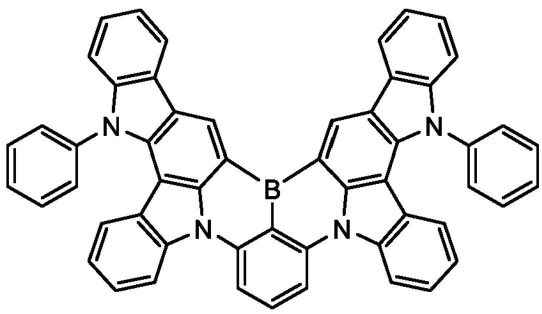
52

[C10]

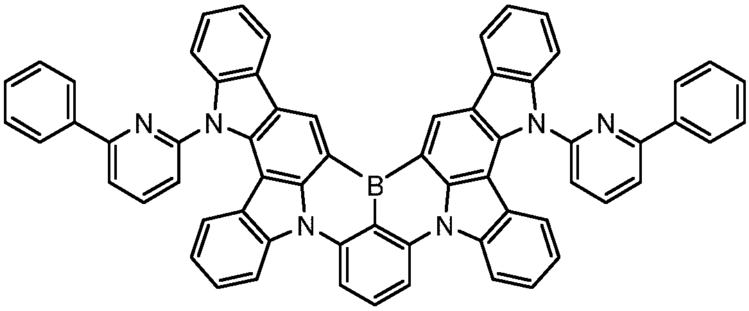

53

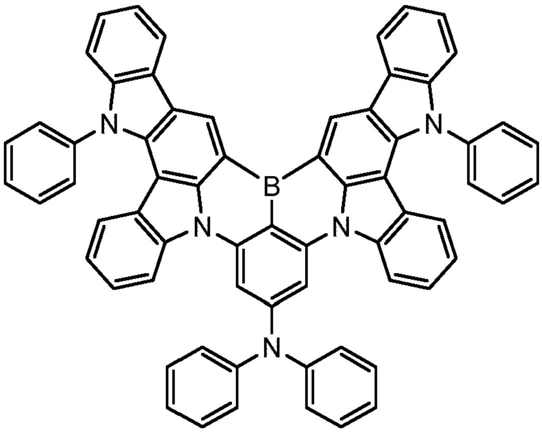

54

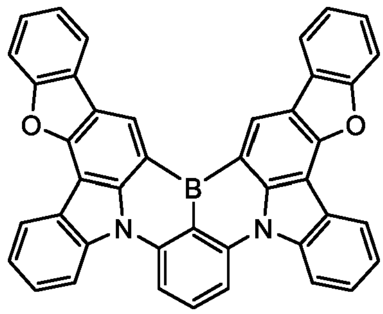

55

[C11]

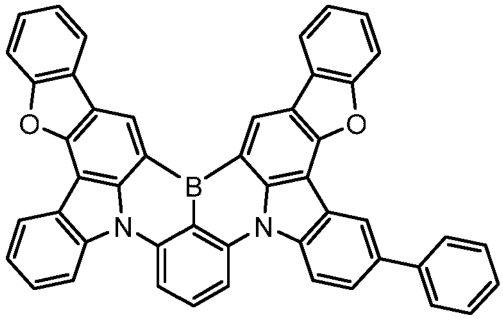

56

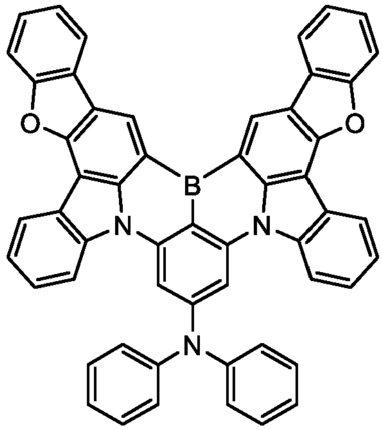

57

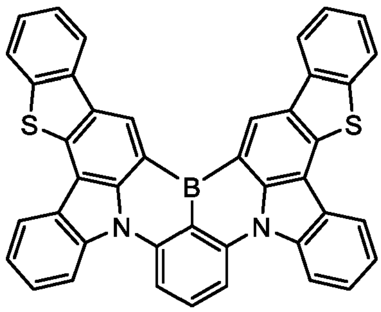

58

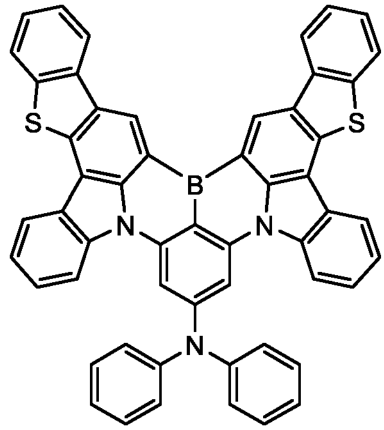

59

[C12]

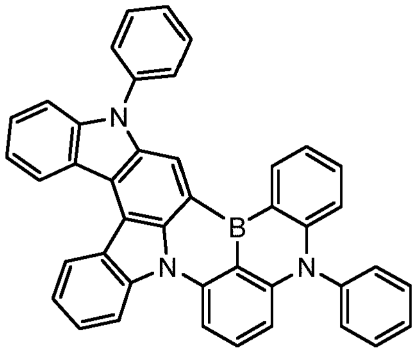

60

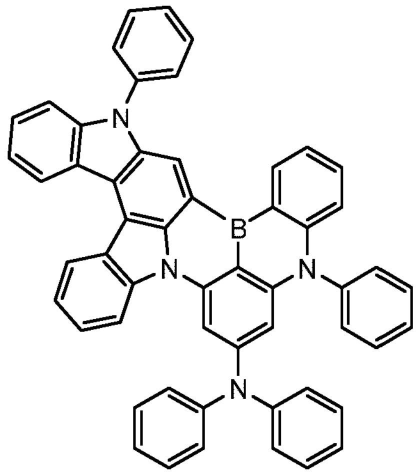

61

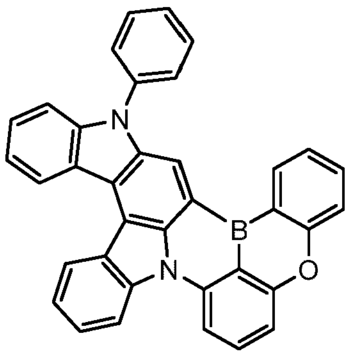

62

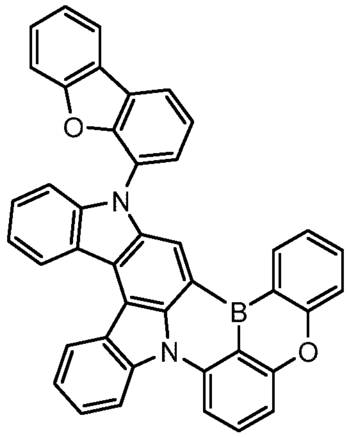

63

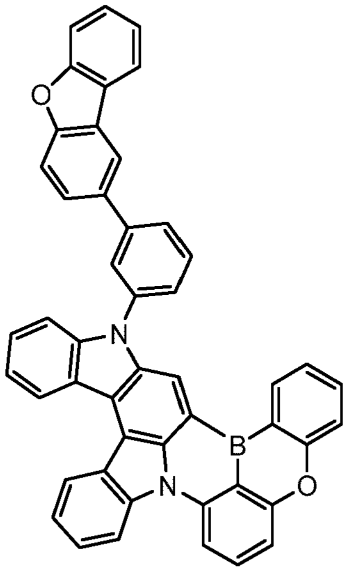

64

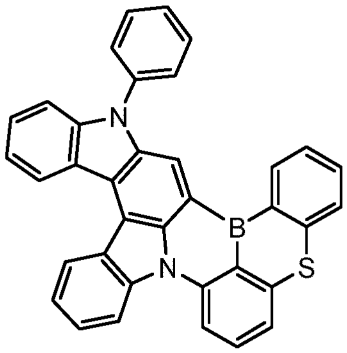

65

[C13]

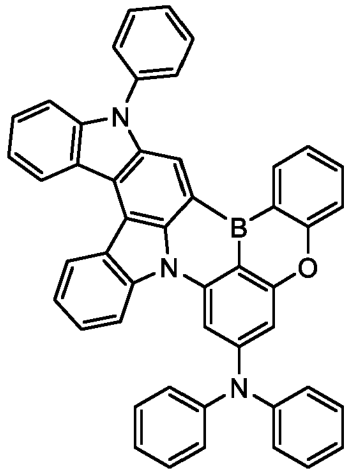
66

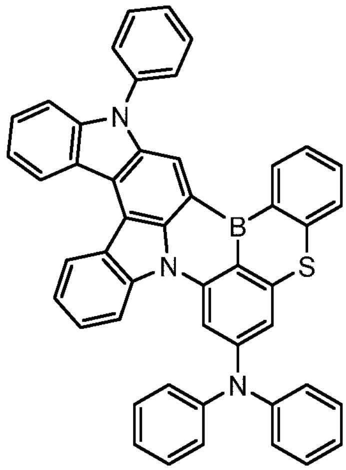
67

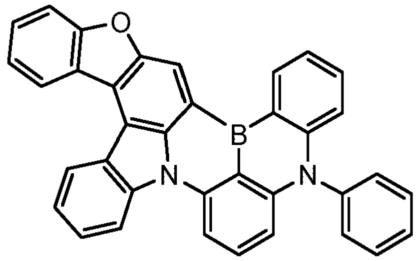
68

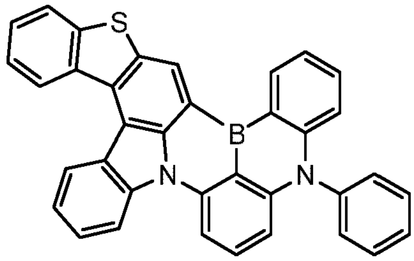
69

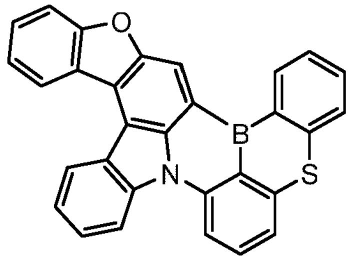
70

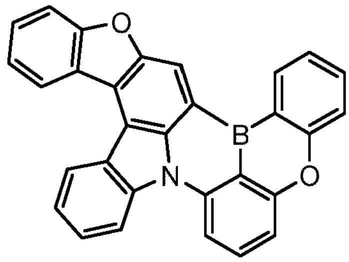
71

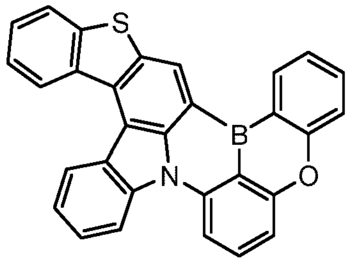
72

[C14]

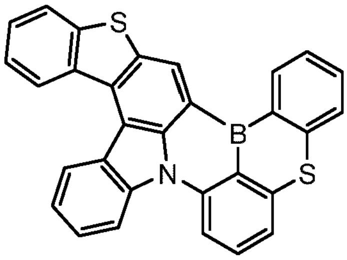

73

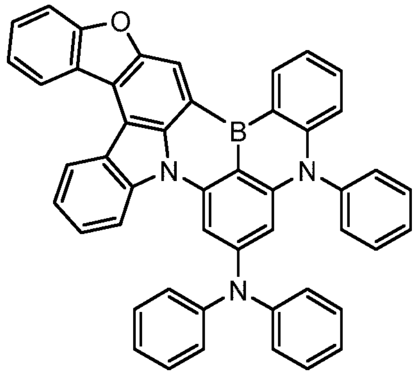

74

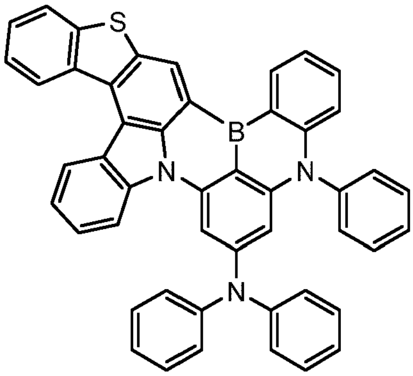

75

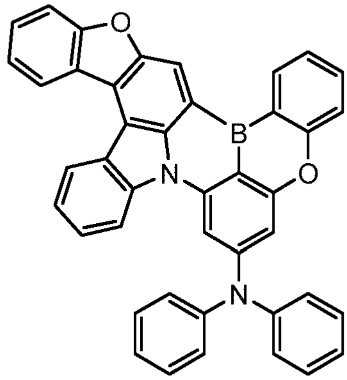

76

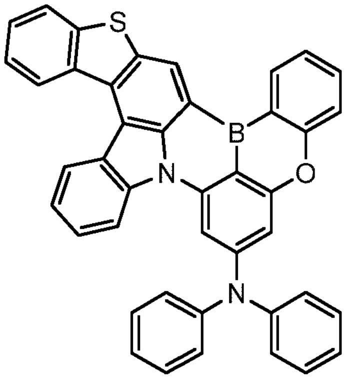

77

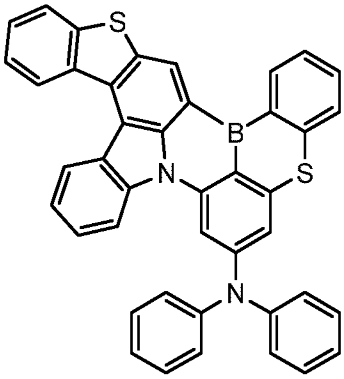

78

[C15]

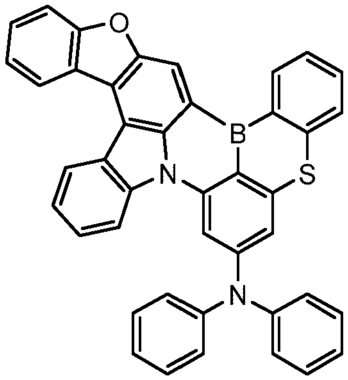
79

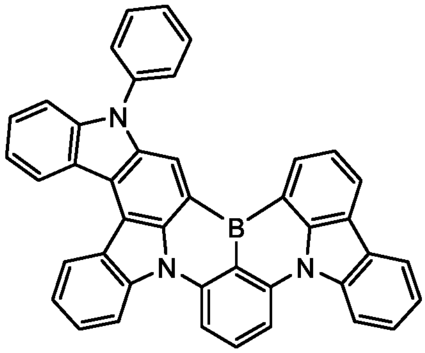
80

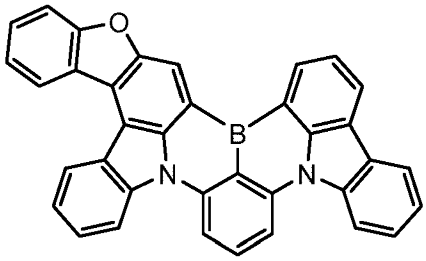
81

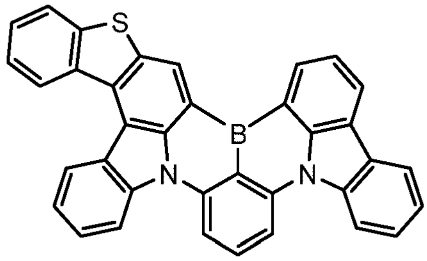
82

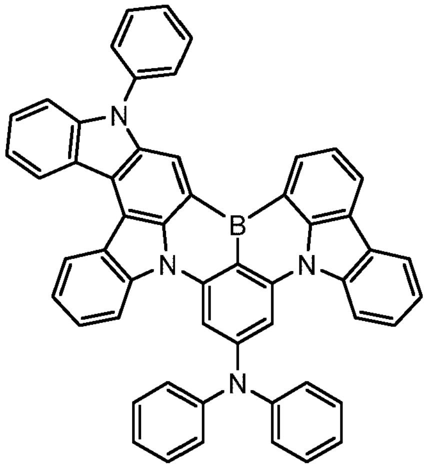
83

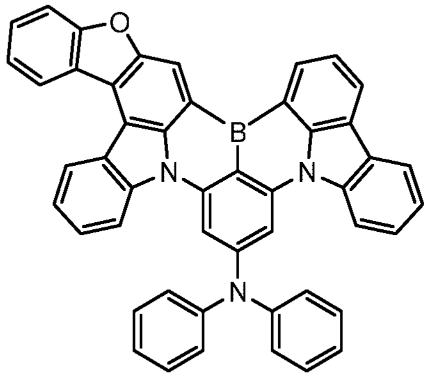
84

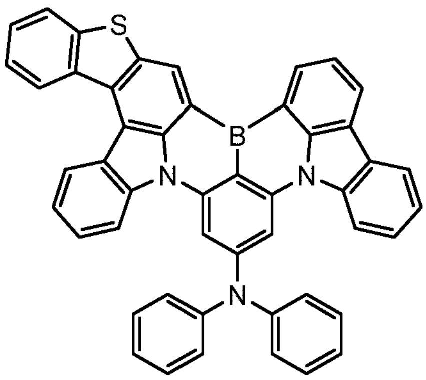
85

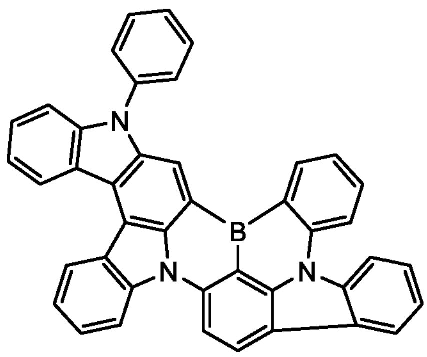
86

[C16]

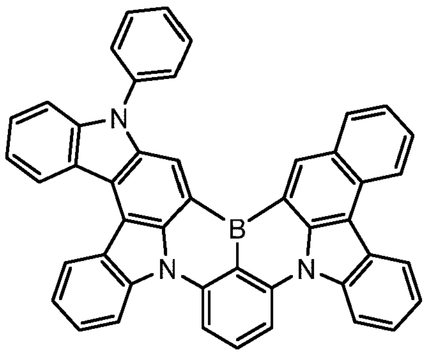

87

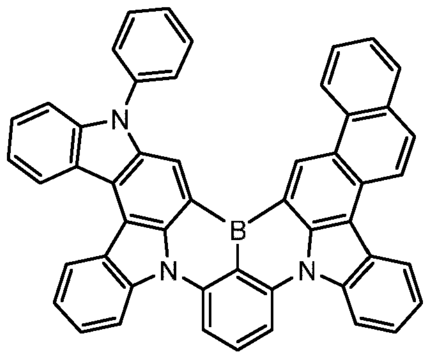

88

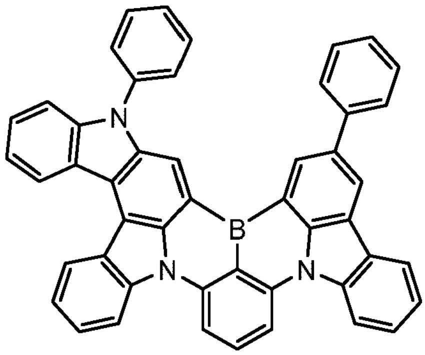

89

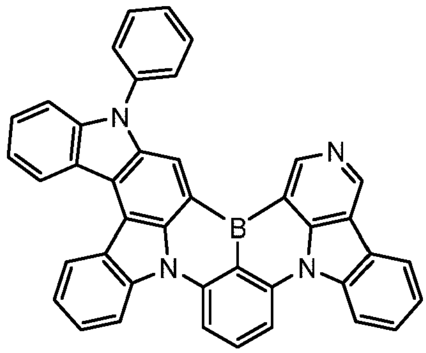

90

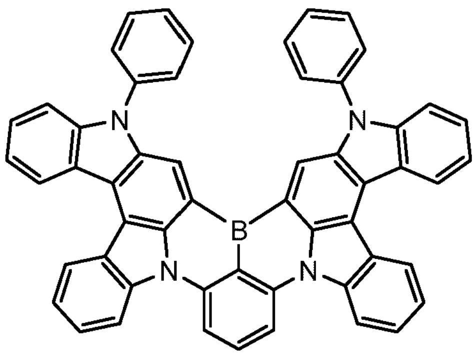

91

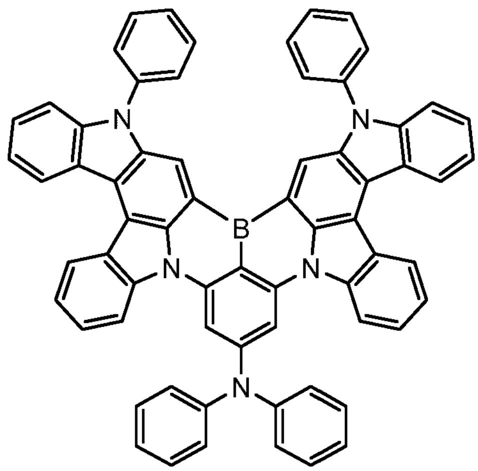

92

[C17]

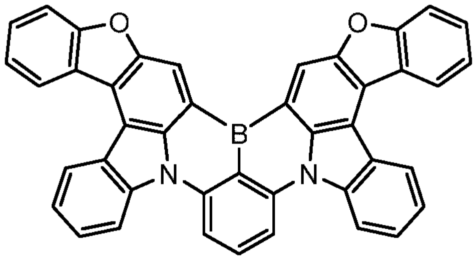

93

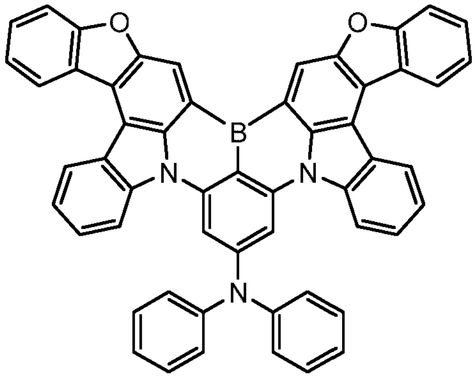

94

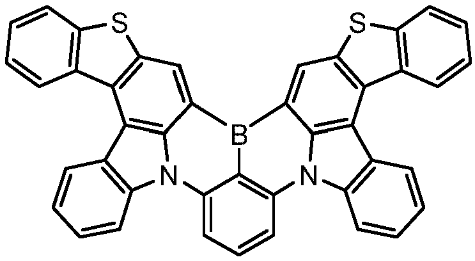

95

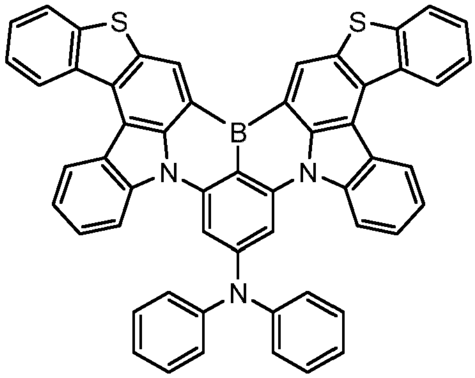

96

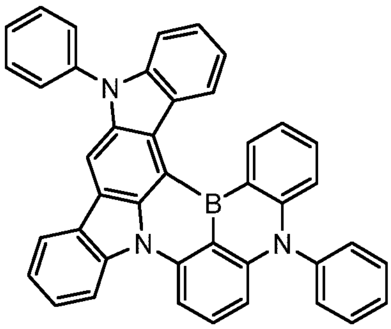

97

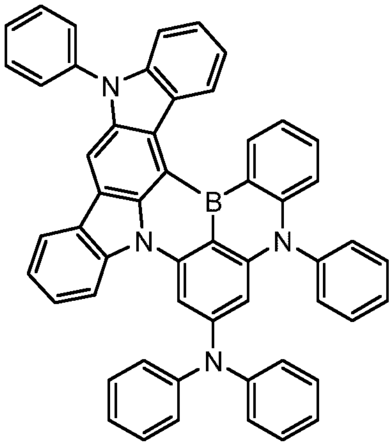

98

[C18]

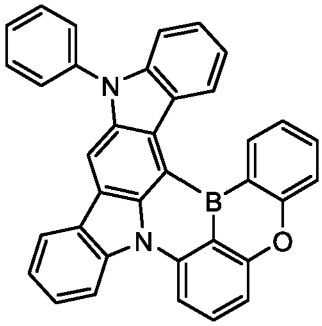
99

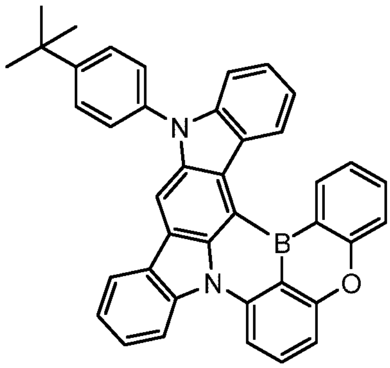
100

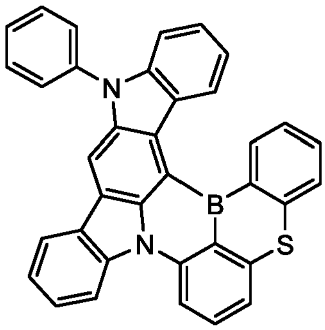
101

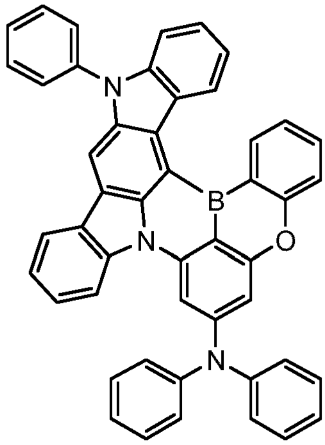
102

[C19]

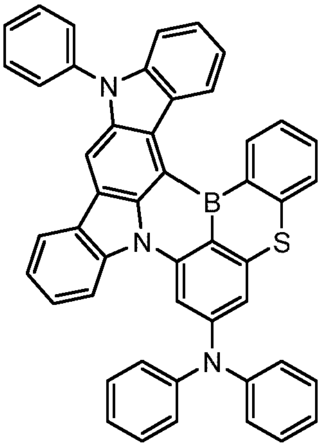

103

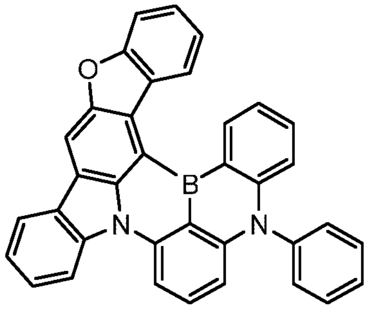

104

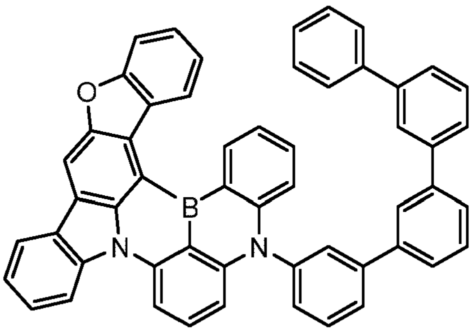

105

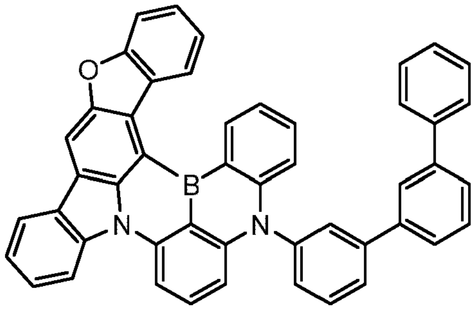

106

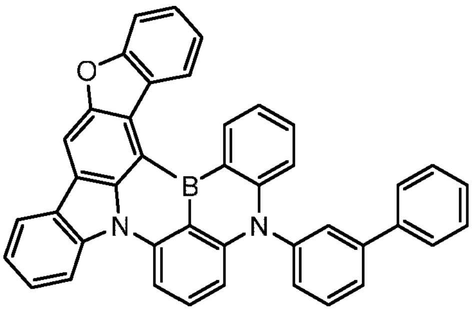

107

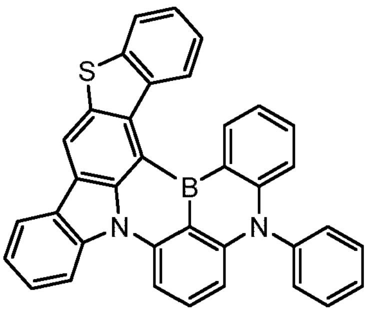

108

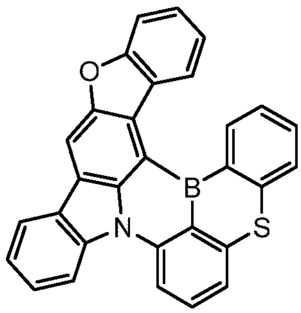

109

[C20]

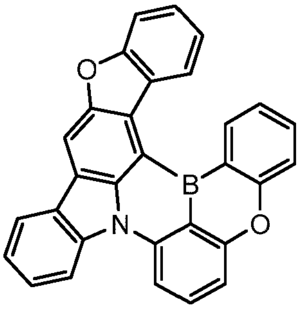
110

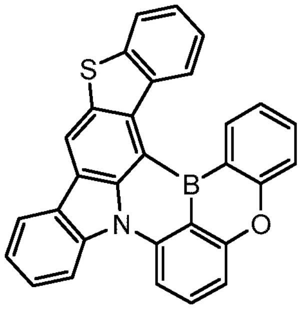
111

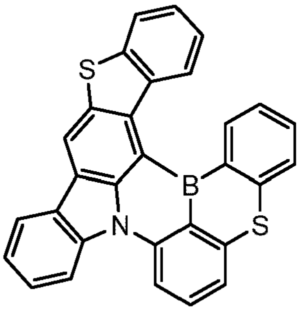
112

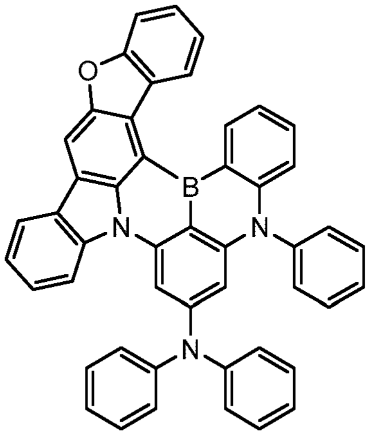
113

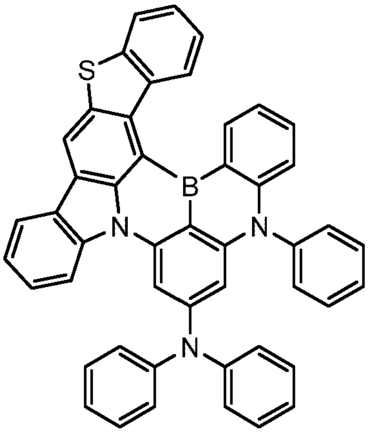
114

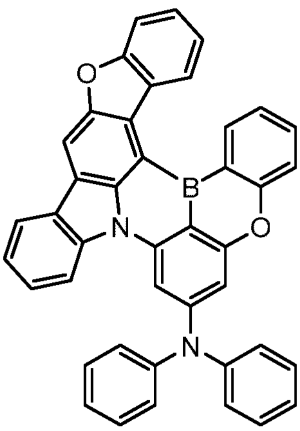
115

[C21]

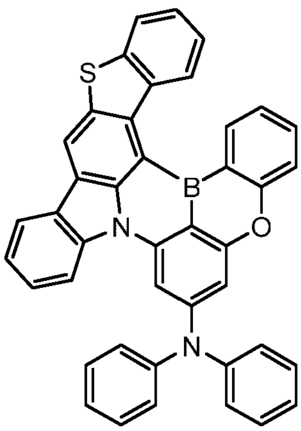

116

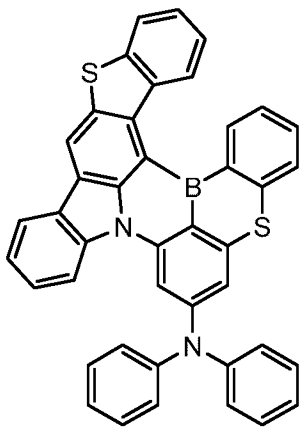

117

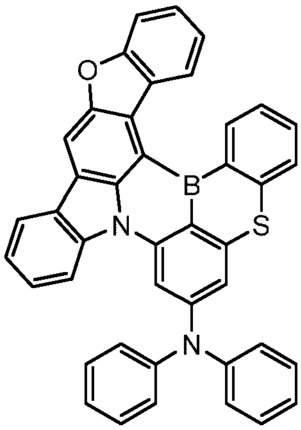

118

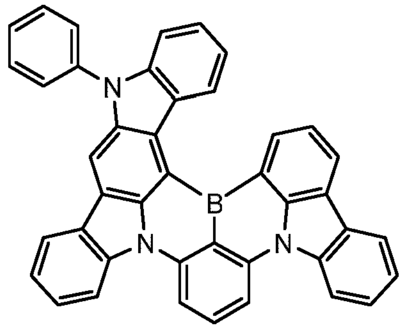

119

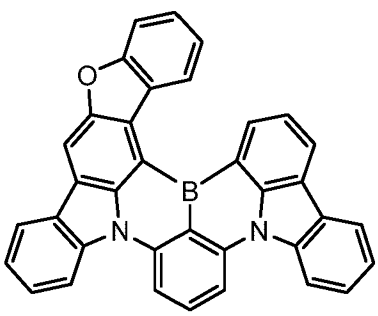

120

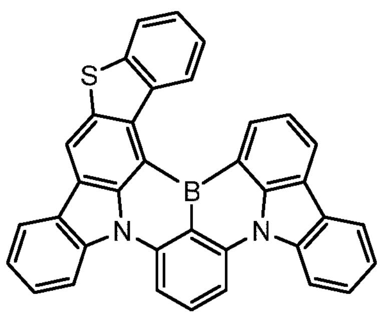

121

[C22]

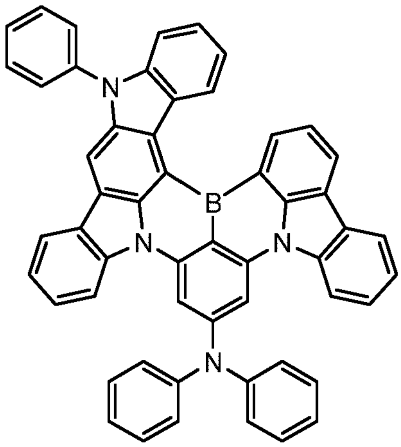

122

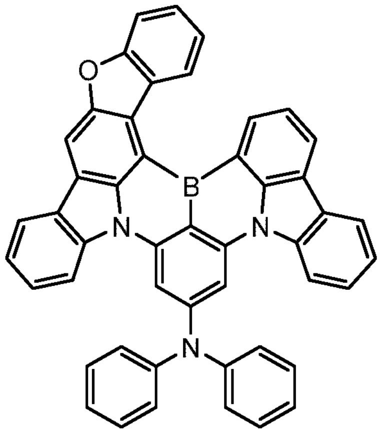

123

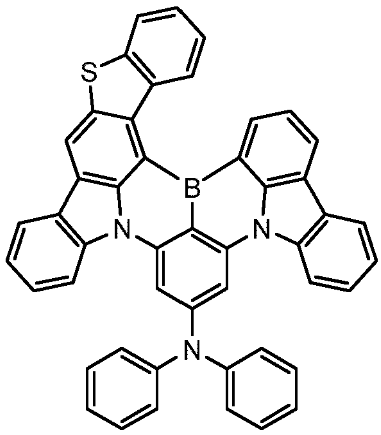

124

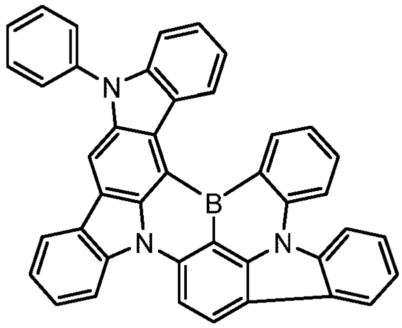

125

[C23]

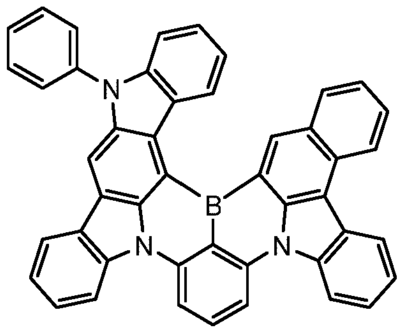

126

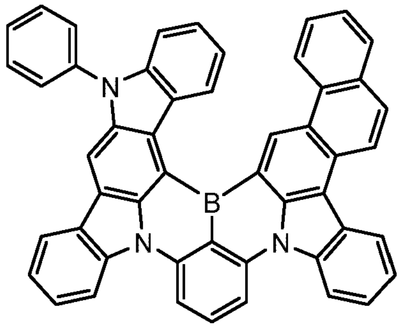

127

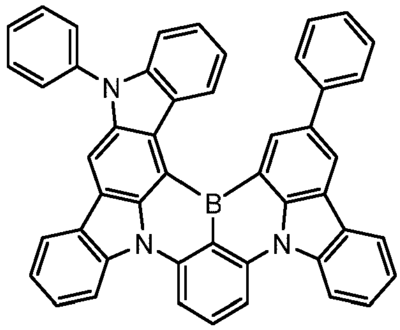

128

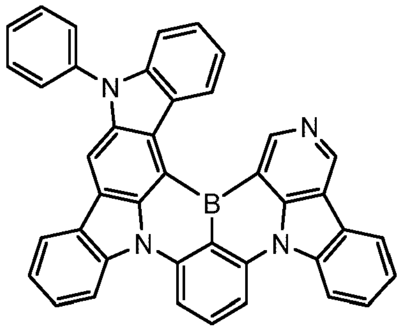

129

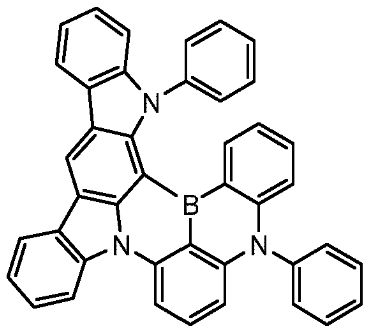

130

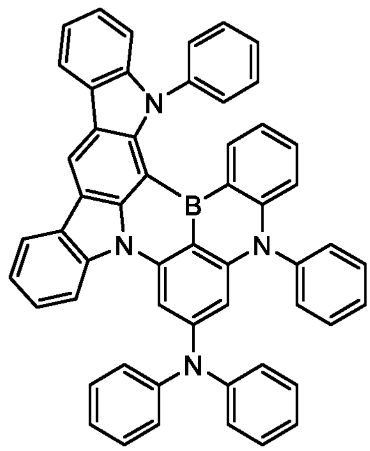

131

[C24]

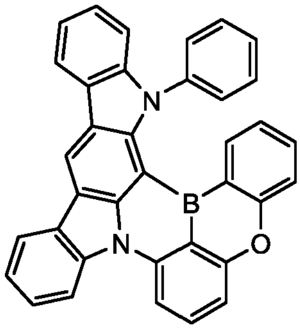

132

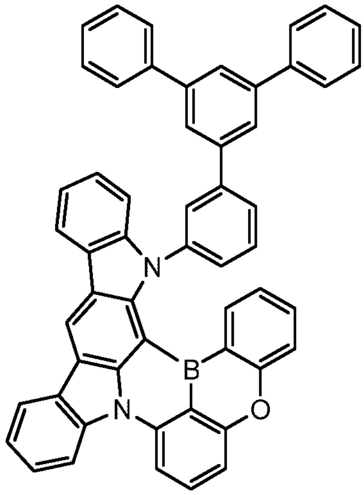

133

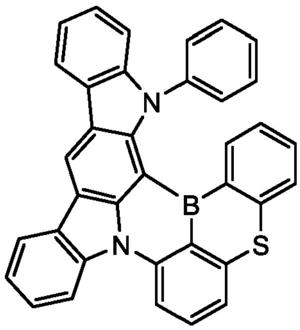

134

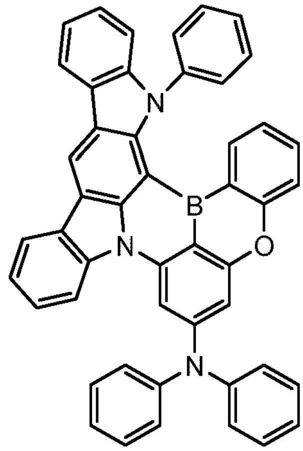

135

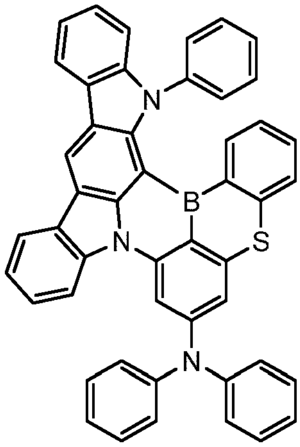

136

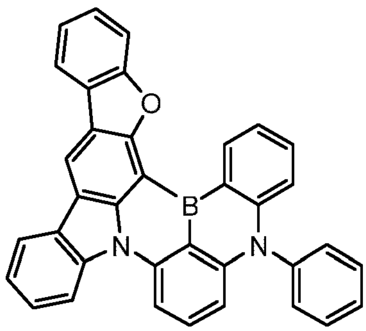

137

[C25]

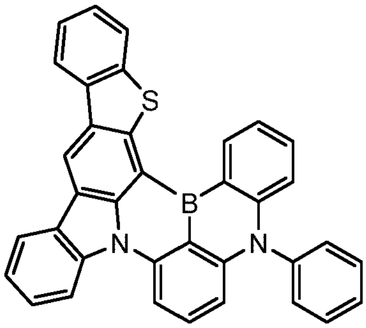
138

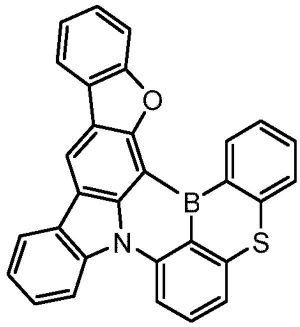
139

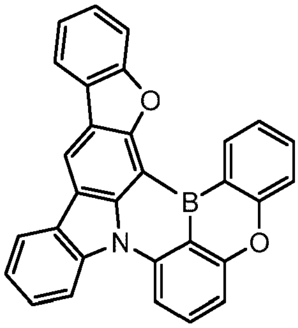
140

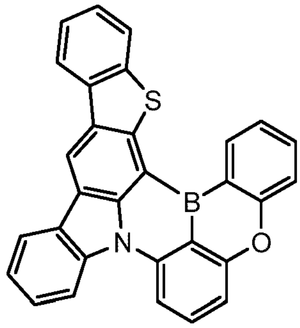
141

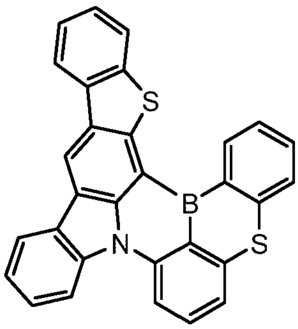
142

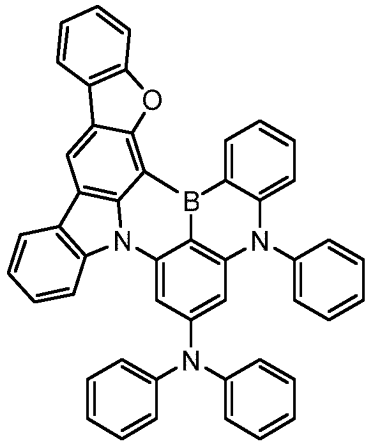
143

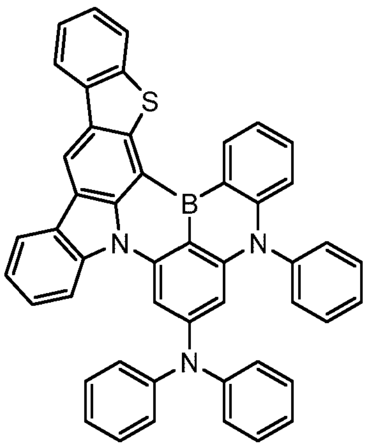
144

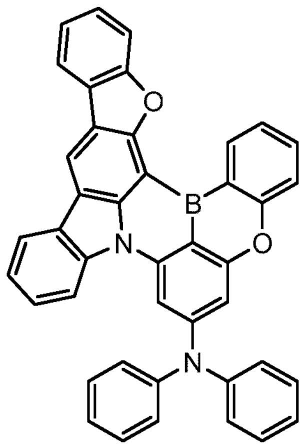
145

[C26]

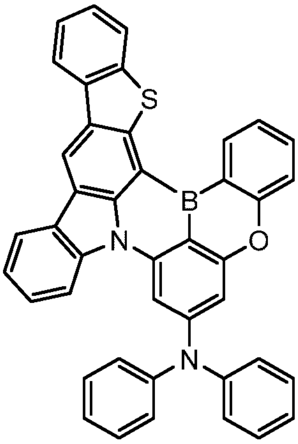
146

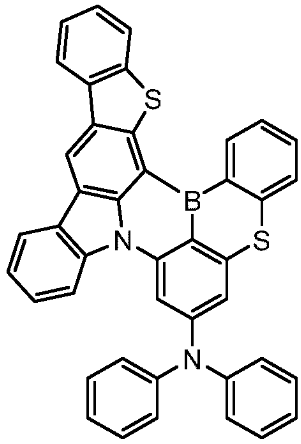
147

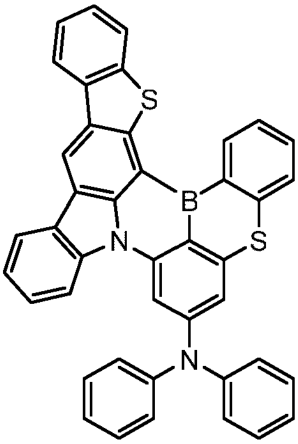
148

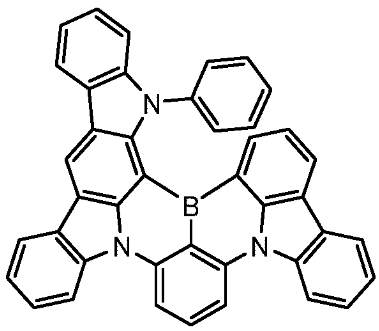
149

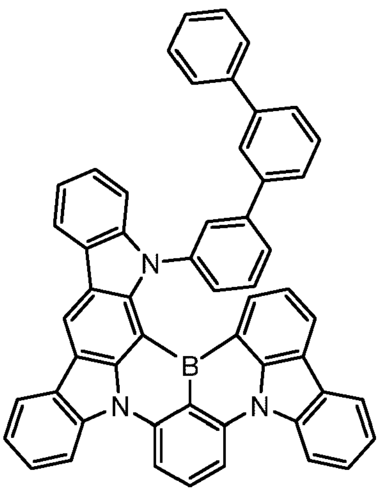
150

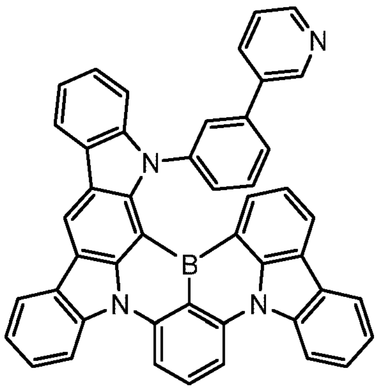
151

[C27]

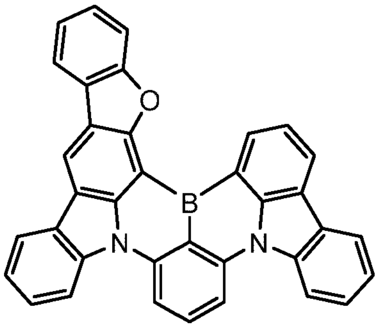

152

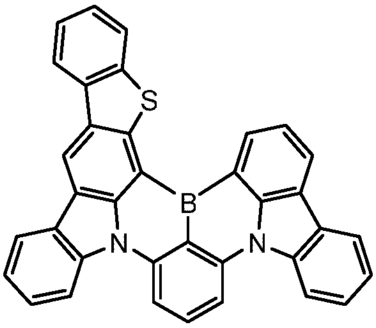

153

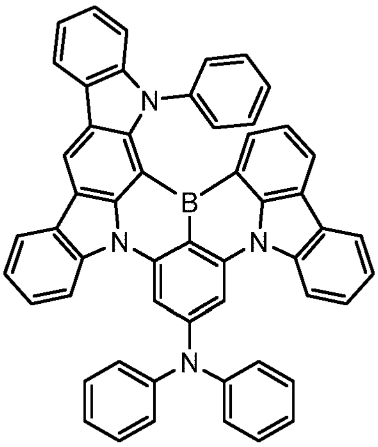

154

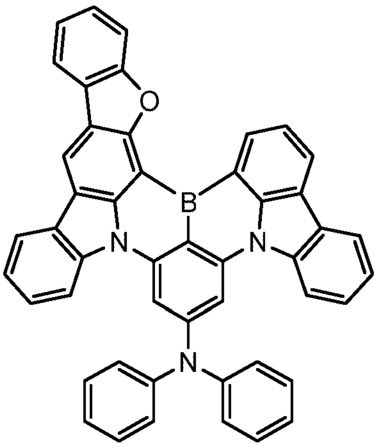

155

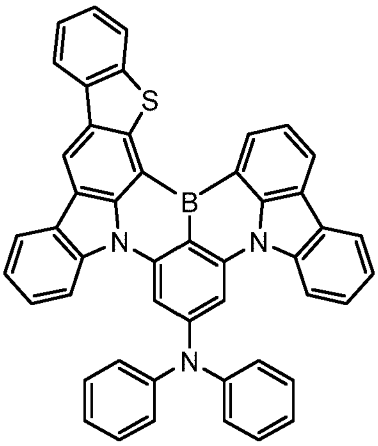

156

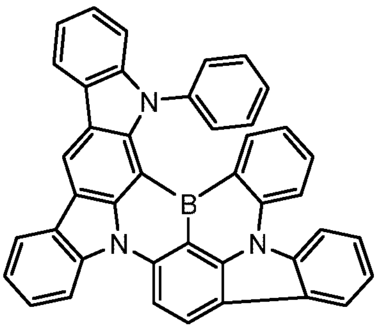

157

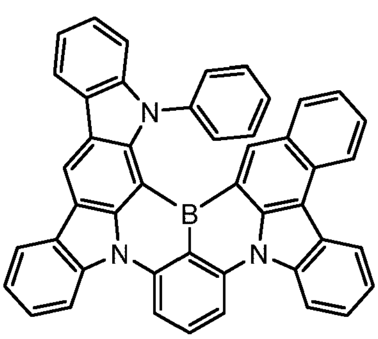

158

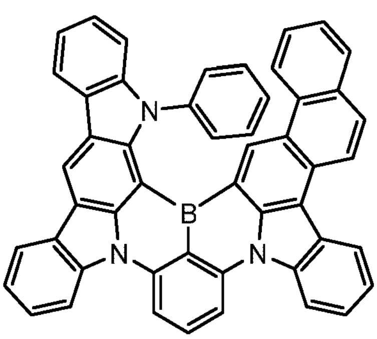

159

[C28]

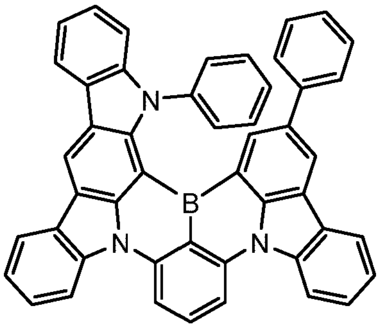

160

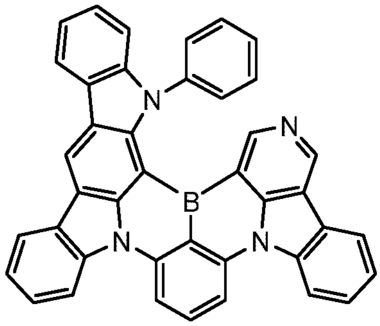

161

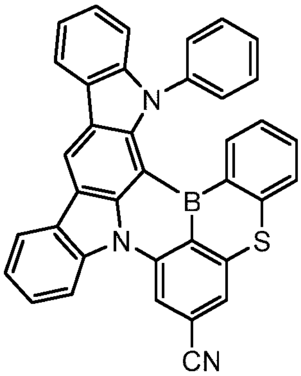

162

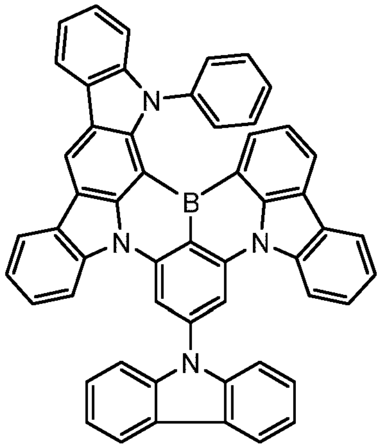

163

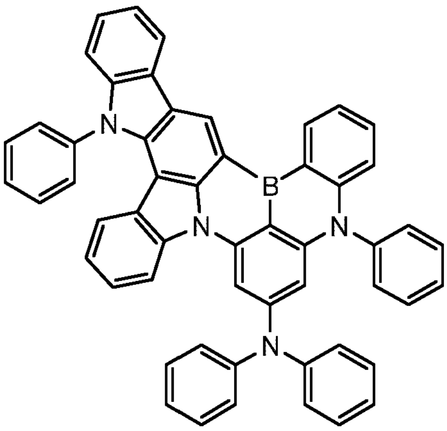

164

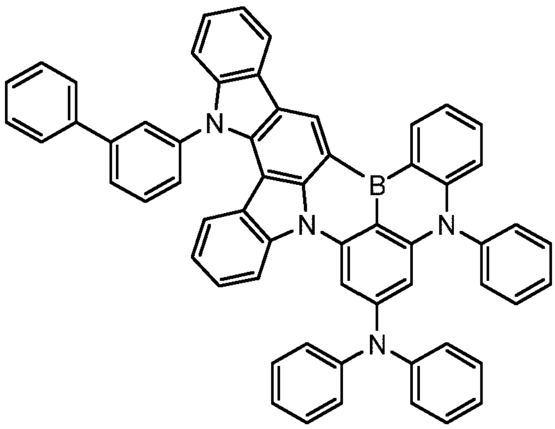

165

By incorporating the emission material represented by the general formula (1) into a light emitting layer, a practically excellent organic EL device having high emission efficiency and high driving stability can be provided.

The light emitting layer can also contain a host material together with the emission material represented by the general formula (1), as necessary. A more excellent organic EL device can be provided by incorporating the host material.

At least one of such host materials is preferably a triazine compound or an anthracene compound.

More preferred examples of the host material include compounds represented by the following general formulas.

[C29]

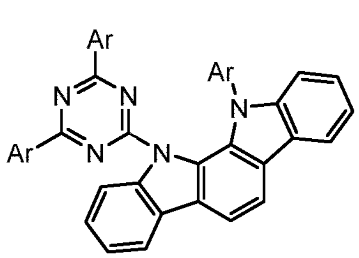
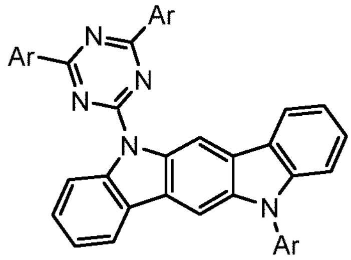
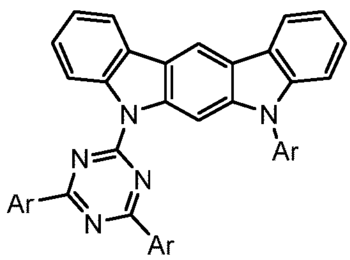

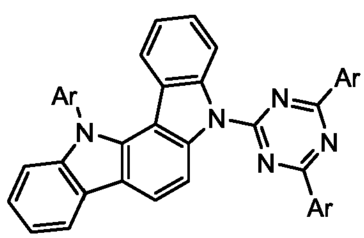
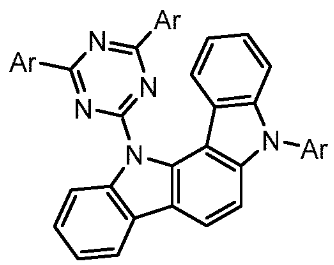
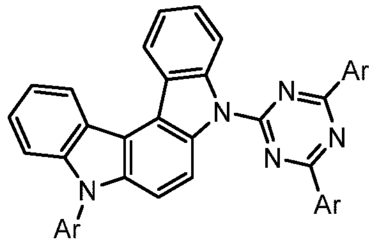

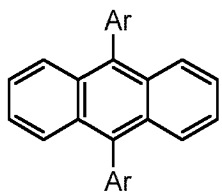

In the formulas, each Ar independently represents a substituted or unsubstituted aromatic hydrocarbon group having 6 to 20 carbon atoms, a substituted or unsubstituted aromatic heterocyclic group having 2 to 20 carbon atoms, or a substituted or unsubstituted linked aromatic group formed by linking 2 to 3 aromatic groups selected from the aromatic hydrocarbon group and the aromatic heterocyclic group. Each Ar preferably represents a substituted or unsubstituted aromatic hydrocarbon group having 6 to 15 carbon atoms, a substituted or unsubstituted aromatic heterocyclic group having 2 to 15 carbon atoms, or a substituted or unsubstituted linked aromatic group formed by linking 2 to 3 aromatic groups selected from the aromatic hydrocarbon group and the aromatic heterocyclic group. Each Ar more preferably represents a substituted or unsubstituted aromatic hydrocarbon group having 6 to 15 carbon atoms, or a substituted or unsubstituted linked aromatic group formed by linking 2 to 3 aromatic groups selected from the aromatic hydrocarbon group.

Specific examples of the unsubstituted Ar include benzene, naphthalene, acenaphthene, acenaphthylene, azulene, anthracene, chrysene, pyrene, phenanthrene, triphenylene, fluorene, benzo[a]anthracene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a group formed by linking 2 to 3 these aromatic groups. Preferred examples thereof include benzene, naphthalene, acenaphthene, acenaphthylene, azulene, anthracene, phenanthrene, fluorene, pyridine, pyrimidine, triazine, thiophene, isothiazole, thiazole, pyridazine, pyrrole, pyrazole, imidazole, triazole, thiadiazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, and a linked aromatic group formed by linking 2 to 3 these aromatic groups. More preferred examples thereof include benzene, naphthalene, acenaphthene, acenaphthylene, azulene, anthracene, phenanthrene, fluorene, and a linked aromatic group formed by linking 2 to 3 these aromatic groups.

Preferred examples of the host specifically include, but are not particularly limited to, the following.

[C30]

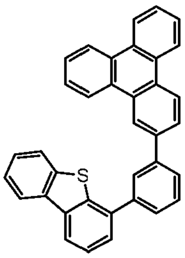
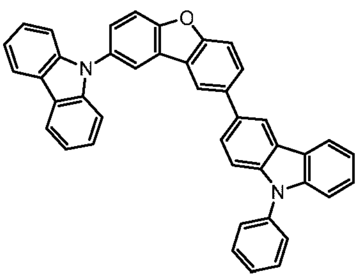
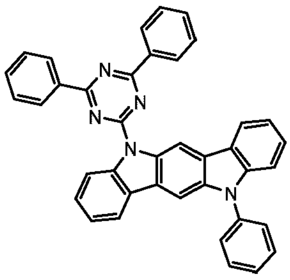
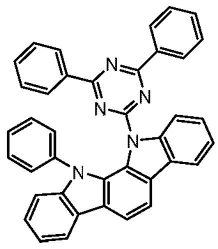

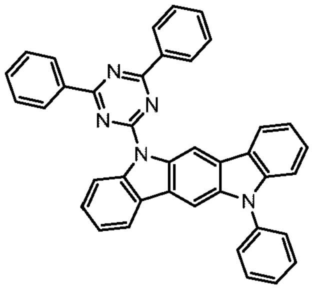
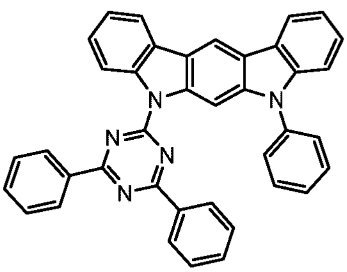
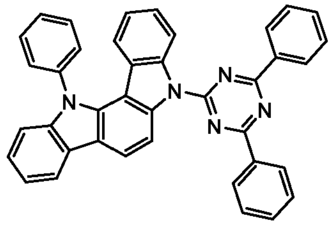

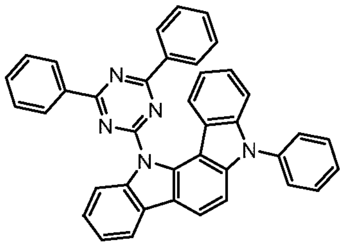
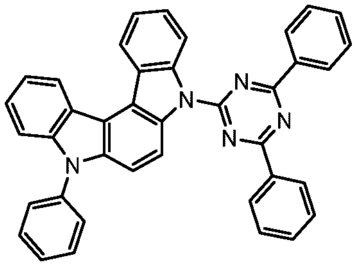
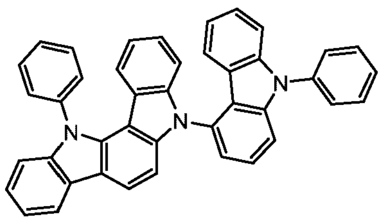

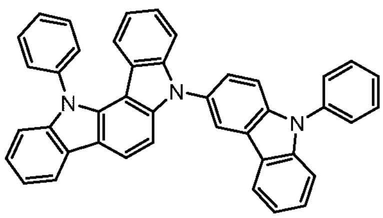
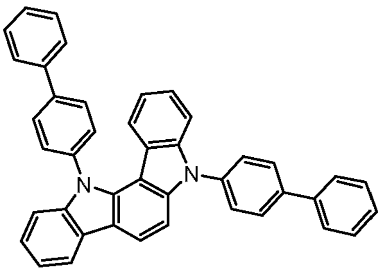

[C31]

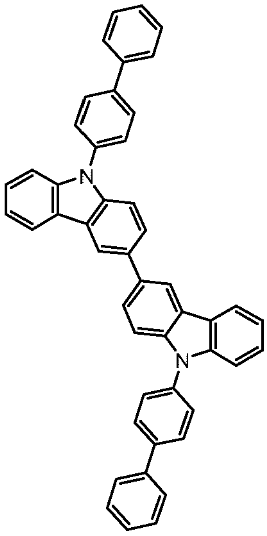
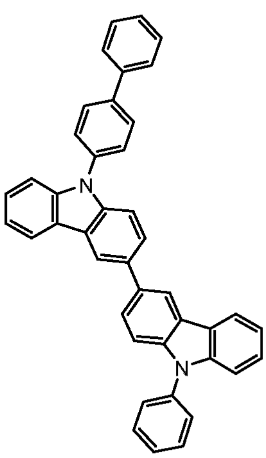
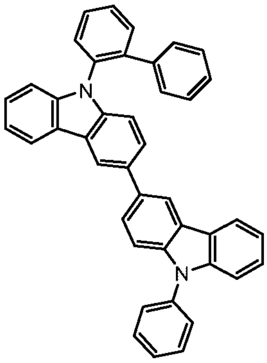
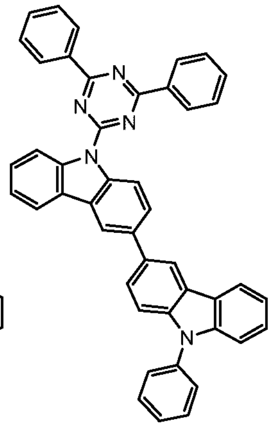

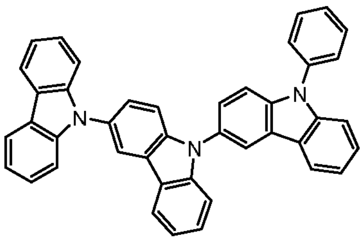
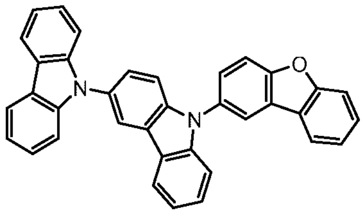
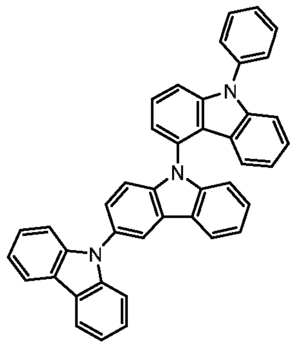

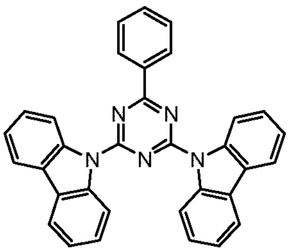
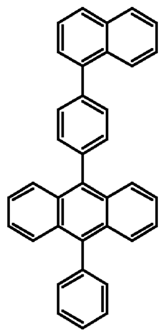
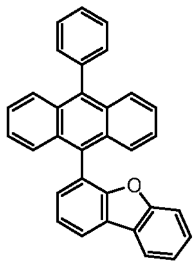

Next, the structure of the organic EL device of the present invention will be described with reference to the drawing, but the structure of the organic EL device of the present invention is not limited thereto.

Figure 1 shows a cross-sectional view of a structure example of a typical organic EL device used in the present invention. Reference numeral 1 denotes a substrate, reference numeral 2 denotes an anode, reference numeral 3 denotes a hole injection layer, reference numeral 4 denotes a hole transport layer, reference numeral 5 denotes a light emitting layer, reference numeral 6 denotes an electron transport layer, and reference numeral 7 denotes a cathode. The organic EL device of the present invention may have an exciton blocking layer adjacent to the light emitting layer, or may have an electron blocking layer between the light emitting layer and the hole injection layer. The exciton blocking layer may be inserted on either the cathode side or the anode side of the light emitting layer or may be inserted on both sides at the same time. The organic EL device of the present invention has the anode, the light emitting layer, and the cathode as essential layers, but preferably has a hole injection/transport layer and an electron injection/transport layer in addition to the essential layers, and further preferably has a hole blocking layer between the light emitting layer and the electron injection/transport layer. The hole injection/transport layer means either or both of the hole injection layer and the hole

transport layer, and the electron injection/transport layer means either or both of the electron injection layer and electron transport layer.

It is also possible to have a structure that is the reverse of the structure shown in Figure 1, that is, the cathode 7, the electron transport layer 6, the light emitting layer 5, the hole transport layer 4, the hole injection layer 3, and the anode 2 can be laminated on the substrate 1, in the order presented. Also, in this case, layers can be added or omitted, as necessary. In the organic EL device as described above, layers other than electrodes such as an anode and a cathode, the layers constituting a multilayer structure on a substrate, may be collectively referred to as an organic layer in some cases.

-Substrate-

The organic EL device of the present invention is preferably supported on a substrate. The substrate is not particularly limited and may be a substrate conventionally used for organic EL devices, and for example, a substrate made of glass, transparent plastic, or quartz can be used.

-Anode-

As the anode material in the organic EL device, a material made of a metal, alloy, or conductive compound having a high work function (4 eV or more), or a mixture thereof is preferably used. Specific examples of such an electrode material include metals such as Au, and conductive transparent materials such as CuI, indium tin oxide (ITO), $SnO_2$, and ZnO. An amorphous material capable of producing a transparent conductive film such as IDIXO ($In_2O_3$-ZnO) may also be used. As the anode, these electrode materials may be formed into a thin film by a method such as vapor deposition or sputtering, and then a pattern of a desired form may be formed by photolithography. Alternatively, when a highly precise pattern is not required (about 100 $\mu$m or more), a pattern may be formed through a mask of a desired form at the time of vapor deposition or sputtering of the above electrode materials. Alternatively, when a coatable material such as an organic conductive compound is used, a wet film forming method such as a printing method and a coating method can also be used. When light is extracted from the anode, the transmittance is desirably more than 10%, and the sheet resistance as the anode is preferably several hundred $\Omega$/square or less. The film thickness is selected within a range of usually 10 to 1,000 nm, and preferably 10 to 200 nm, although it depends on the material.

-Cathode-

On the other hand, a material made of a metal (referred to as an electron injection metal), alloy, or conductive compound having a low work function (4 eV or less) or a mixture thereof is used as the cathode material. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide ($Al_2O_3$) mixture, indium, a lithium/aluminum mixture, and a rare earth metal. Among them, in terms of electron injection properties and durability against oxidation and the like, a mixture of an electron injection metal with a second metal that has a higher work function value than the electron injection metal and is stable, for example, a magnesium/silver mixture, a magnesium/aluminum mixture, a magnesium/indium mixture, an aluminum/aluminum oxide ($Al_2O_3$) mixture, a lithium/aluminum mixture, or aluminum is suitable. The cathode can be produced by forming a thin film from these cathode materials by a method such as vapor deposition and sputtering. The sheet resistance as the cathode is preferably several hundred $\Omega$/square or less, and the film thickness is selected within a range of usually 10 nm to 5 $\mu$m, and preferably 50 to 200 nm. To transmit the light emitted, either one of the anode and the cathode of the organic EL device is favorably transparent or translucent because light emission brightness is improved.

The above metal is formed to have a film thickness of 1 to 20 nm, and then a conductive transparent material mentioned in the description of the anode is formed on the metal, so that a transparent or translucent cathode can be produced. By applying this process, a device in which both anode and cathode have transmittance can be produced.

-Light Emitting Layer-

The light emitting layer is a layer that emits light after holes and electrons respectively injected from the anode and the cathode are recombined to form exciton. For the light emitting layer, the emission material represented by the general formula (1) may be used alone, or the emission material may be used in combination with a host material. When the emission material is used together with the host material, the emission material serves as a light emitting dopant.

The emission material represented by the general formula (1) may also be used together with a fluorescence material other than those represented by the general formula (1). When the emission material represented by the general formula (1) is used together with the fluorescence material, the emission material may be further used together with a host material. When the emission material represented by the general formula (1) is used with a fluorescence material, the

fluorescence material serves as a light emitting dopant.

The content of the light emitting dopant is preferably 0.1 to 50 wt%, and more preferably 0.1 to 40 wt% based on the host material.

The host material in the light emitting layer can be a known host material used for a phosphorescent device or a fluorescent device, other than the host material shown above. A usable known host material is a compound having the ability to transport hole, the ability to transport electron, and a high glass transition temperature, and preferably has a higher triplet excited energy (T1) than the triplet excited energy (T1) of the emission material represented by the general formula (1). A TADF-active compound may also be used as the host material, and the TADF-active compound preferably has a difference (ΔEST = S1 - T1) between the singlet excited energy (S1) and the triplet excited energy (T1), of 0.20 eV or less.

Here, S1 and T1 are measured as follows.

A sample compound (thermally activated delayed fluorescence material) is deposited on a quartz substrate by a vacuum deposition method under conditions of a degree of vacuum of $10^{-4}$ Pa or less to form a deposition film having a thickness of 100 nm. For S1, the emission spectrum of this deposition film is measured, a tangent is drawn to the rise of the emission spectrum on the short-wavelength side, and the wavelength value λedge [nm] of the point of intersection of the tangent and the horizontal axis is substituted into the following equation (i) to calculate S1.

$$S1\ [eV] = 1239.85/\lambda edge \qquad (i)$$

For T1, on the other hand, the phosphorescence spectrum of the above deposition film is measured, a tangent is drawn to the rise of the phosphorescence spectrum on the short-wavelength side, and the wavelength value λedge [nm] of the point of intersection of the tangent and the horizontal axis is substituted into the following equation (ii) to calculate T1.

$$T1\ [eV] = 1239.85/\lambda edge \qquad (ii)$$

Such host materials are known in a large number of Patent Literatures and the like, and hence may be selected from them. Specific examples of the host material include, but are not particularly limited to, various metal complexes typified by metal complexes of indole compounds, carbazole compounds, indolocarbazole compounds, pyridine compounds, pyrimidine compounds, triazine compounds, triazole compounds, oxazole compounds, oxadiazole compounds, imidazole compounds, phenylenediamine compounds, arylamine compounds, anthracene compounds, fluorenone compounds, stilbene compounds, triphenylene compounds, carborane compounds, porphyrin compounds, phthalocyanine compounds, and 8-quinolinol compounds, and metal phthalocyanine, and metal complexes of benzoxazole and benzothiazole compounds; and polymer compounds such as poly(N-vinyl carbazole) compounds, aniline-based copolymer compounds, thiophene oligomers, polythiophene compounds, polyphenylene compounds, polyphenylene vinylene compounds, and polyfluorene compounds. Preferred examples thereof include carbazole compounds, indolocarbazole compounds, pyridine compounds, pyrimidine compounds, triazine compounds, anthracene compounds, triphenylene compounds, carborane compounds, and porphyrin compounds.

Only one host may be contained or two or more hosts may be used in one light emitting layer. When two or more hosts are used, at least one thereof is preferably an electron-transporting compound, for example, the triazine compounds or anthracene compounds described above, and other host is preferably a hole-transporting compound, for example, the carbazole compounds or indolocarbazole compounds. When a plurality of hosts is used, each host is deposited from different deposition sources, or a plurality of hosts is premixed before vapor deposition to form a premix, whereby a plurality of hosts can be simultaneously deposited from one deposition source.

As the method of premixing, a method by which hosts can be mixed as uniformly as possible is desirable, and examples thereof include, but are not limited to, milling, a method of heating and melting hosts under reduced pressure or under an inert gas atmosphere such as nitrogen, and sublimation.

The host and a premix thereof may be in the form of powder, sticks, or granules.

When a fluorescence material other than those represented by the general formula (1) is used in the light emitting layer, preferred examples of the other fluorescence material include fused polycyclic aromatic derivatives, styrylamine derivatives, fused ring amine derivatives, boron-containing compounds, pyrrole derivatives, indole derivatives, carbazole derivatives, and indolocarbazole derivatives. Among them, fused ring amine derivatives, boron-containing compounds, carbazole derivatives, and indolocarbazole derivatives are preferred.

Examples of the fused ring amine derivatives include diaminepyrene derivatives, diaminochrysene derivatives, diaminoanthracene derivatives, diaminofluorenone derivatives, and diaminofluorene derivatives fused with one or more benzofuro backbones.

Examples of the boron-containing compounds include pyrromethene derivatives and trriphenylborane derivatives.

Preferred examples of the fluorescence material other than those represented by the general formula (1) are not

particularly limited, but specific examples thereof include the following.

[C32]

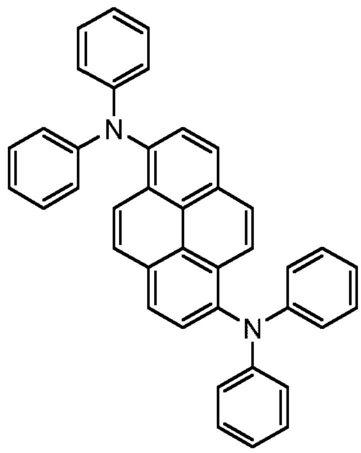

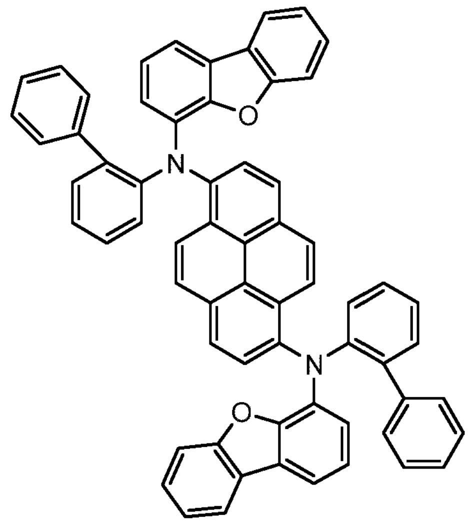

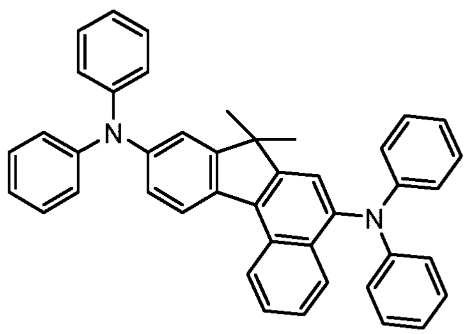

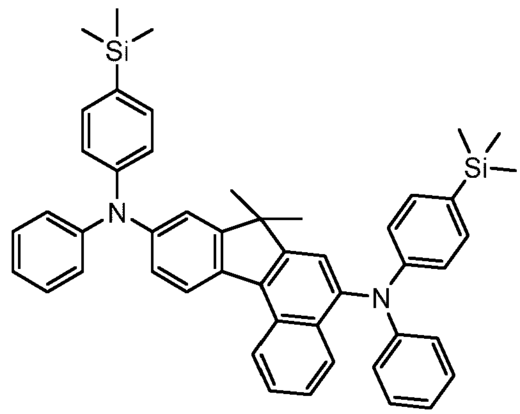

[C33]

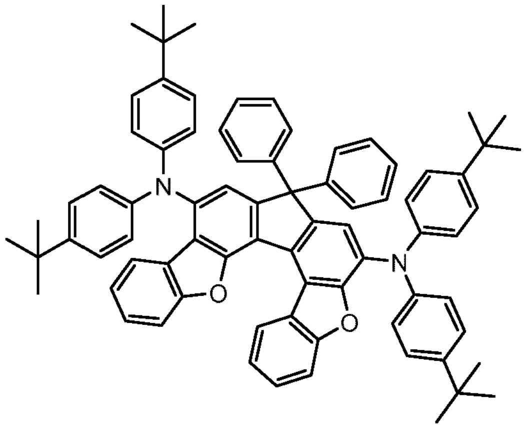

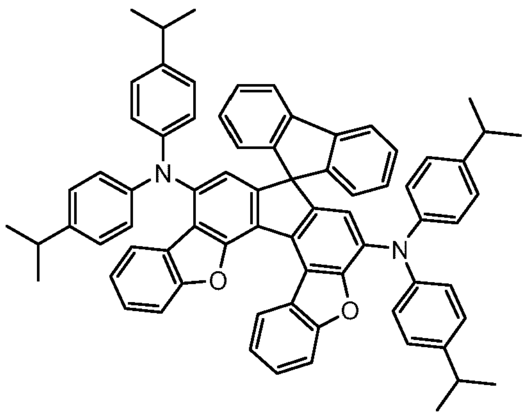

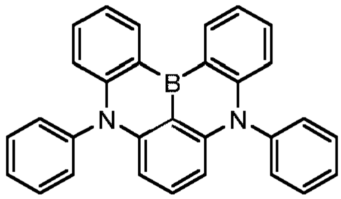

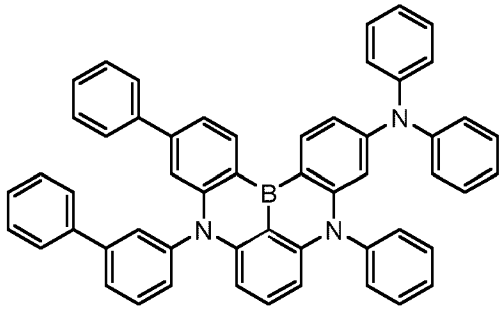

[C34]

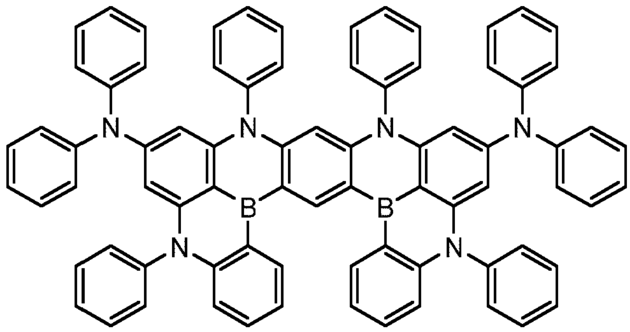

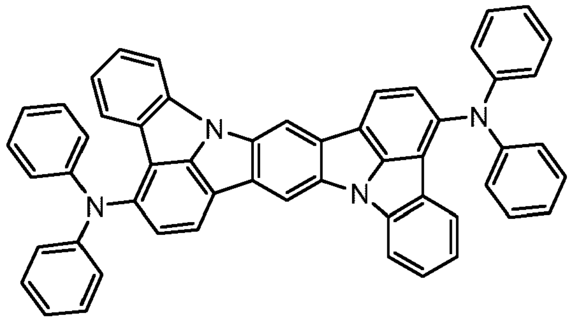

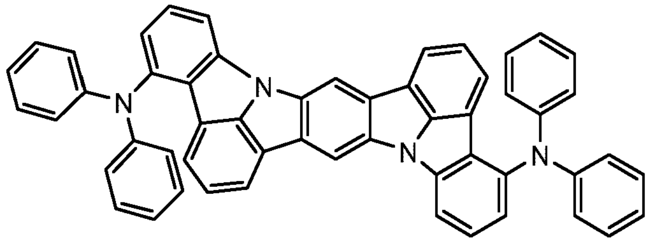

-Injection Layer-

The injection layer refers to a layer provided between the electrode and the organic layer to reduce the driving voltage and improve the light emission brightness, and includes the hole injection layer and the electron injection layer. The injection layer may be present between the anode and the light emitting layer or the hole transport layer, as well as between the cathode and the light emitting layer or the electron transport layer. The injection layer may be provided as necessary.

-Hole Blocking Layer-

The hole blocking layer has the function of the electron transport layer in a broad sense, is made of a hole blocking material having a very small ability to transport holes while having the function of transporting electrons, and can improve the recombination probability between the electrons and the holes in the light emitting layer by blocking the holes while transporting the electrons. For the hole blocking layer, a known hole blocking material can be used. A plurality of hole blocking materials may be used in combination.

-Electron Blocking Layer-

The electron blocking layer has the function of the hole transport layer in a broad sense, and can improve the recombination probability between the electrons and the holes in the light emitting layer by blocking the electrons while transporting the holes. As the material for the electron blocking layer, a known material for the electron blocking layer can be used.

-Exciton Blocking Layer-

The exciton blocking layer is a layer to block the diffusion of the excitons generated by recombination of the holes and the electrons in the light emitting layer into a charge transport layer, and insertion of this layer makes it possible to efficiently keep the excitons in the light emitting layer, so that the emission efficiency of the device can be improved. The exciton blocking layer can be inserted between two light emitting layers adjacent to each other in the device in which two or more light emitting layers are adjacent to each other. As the material for such an exciton blocking layer, a known material for the exciton blocking layer can be used.
The layer adjacent to the light emitting layer includes the hole blocking layer, the electron blocking layer, and the exciton blocking layer, and when these layers are not provided, the adjacent layer is the hole transport layer, the electron transport layer, and the like.

-Hole Transport Layer-

The hole transport layer is made of a hole transport material having the function of transporting holes, and the hole transport layer may be provided as a single layer or a plurality of layers.
The hole transport material has any of hole injection properties, hole transport properties, or electron barrier properties, and may be either an organic material or an inorganic material. As the hole transport layer, any of conventionally known compounds may be selected and used. Examples of such a hole transport material include porphyrin derivatives, arylamine derivatives, triazole derivatives, oxadiazole derivatives, imidazole derivatives, polyarylalkane derivatives, phenylenediamine derivatives, arylamine derivatives, amino-substituted chalcone derivatives, oxazole derivatives, styrylanthracene derivatives, fluorenone derivatives, hydrazone derivatives, stilbene derivatives, silazane derivatives, aniline-based copolymers, and conductive polymer oligomers, particularly, thiophene oligomers. Porphyrin derivatives, arylamine derivatives, and styrylamine derivatives are preferably used, and arylamine compounds are more preferably used.

-Electron Transport Layer-

The electron transport layer is made of a material having the function of transporting electrons, and the electron transport layer may be provided as a single layer or a plurality of layers.
The electron transport material (may also serve as the hole blocking material) has the function of transmitting electrons injected from the cathode to the light emitting layer. As the electron transport layer, any of conventionally known compounds may be selected and used, and examples thereof include polycyclic aromatic derivatives such as naphthalene, anthracene, and phenanthroline, tris(8-quinolinolato)aluminum (III) derivatives, phosphine oxide derivatives, nitro-substituted fluorene derivatives, diphenylquinone derivatives, thiopyran dioxide derivatives, carbodiimides, fluorenylidene methane derivatives, anthraquinodimethane and anthrone derivatives, bipyridine derivatives, quinoline derivatives, oxadiazole derivatives, benzimidazole derivatives, benzothiazole derivatives, and indolocarbazole derivatives. Further, polymer materials in which these materials are introduced in the polymer chain or these materials constitute the main chain of the polymer can also be used.
When the organic EL device of the present invention is produced, the film formation method of each layer is not particularly limited, and the layers may be produced by either a dry process or a wet process.

Examples

Hereinafter, the present invention will be described in further detail with reference to Examples, but the present invention is not limited to these Examples.
The compounds used in Examples and Comparative Examples are shown below.

[C35]

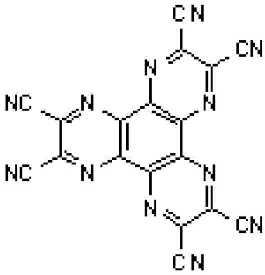

HAT-CN

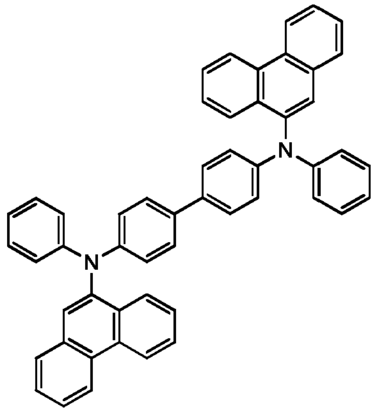

HT-1

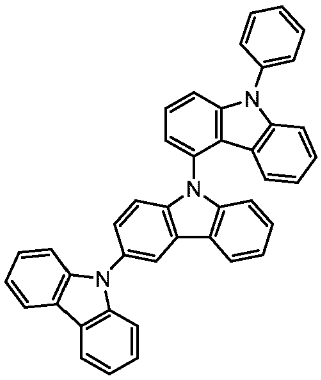

HT-2

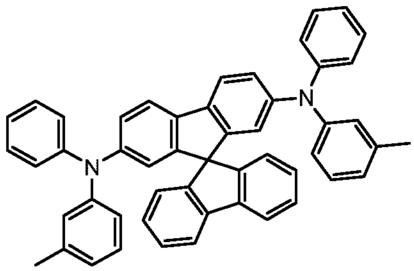

HT-3

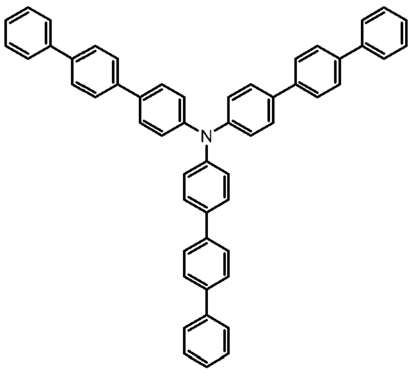

HT-4

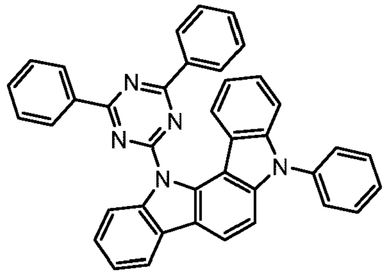

BH-1

[C36]

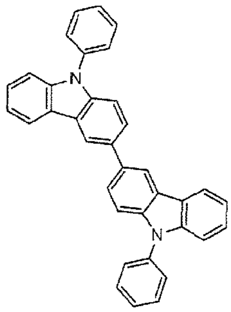
BH-2

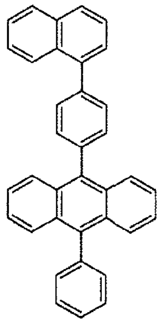
BH-3

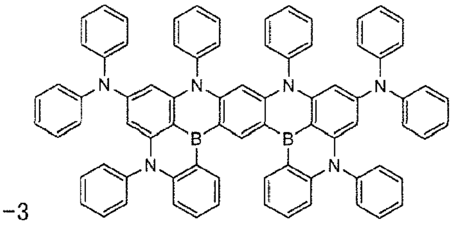
BD-1

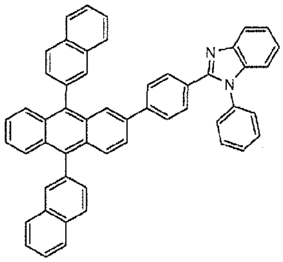
ET-1

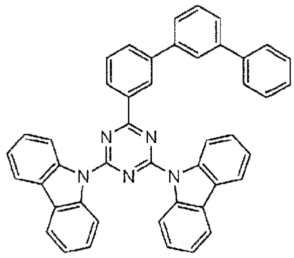
ET-2

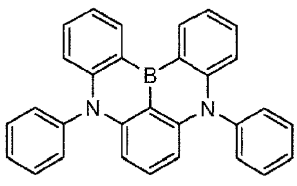
BD-2

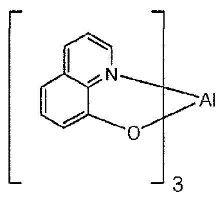
Alq3

Synthesis Example 1

[C37]

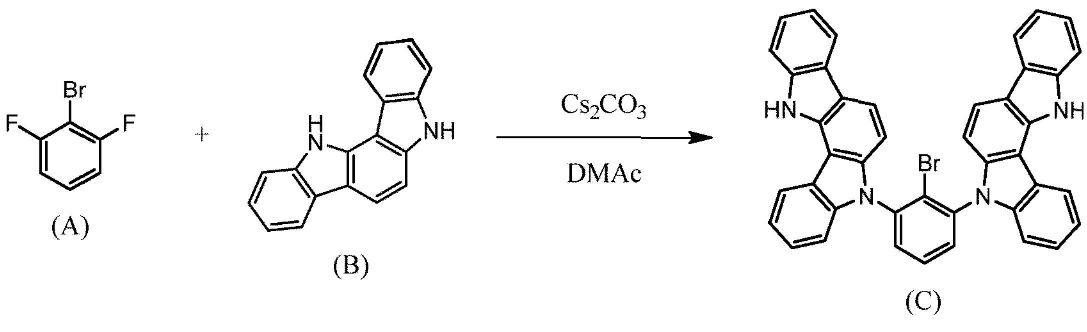


As shown in the above reaction scheme, 6.9 g of a starting material (A), 20.0 g of a starting material (B), 57.8 g of cesium carbonate, and 200 ml of N,N-dimethylacetamide (DMAc) were put in a three-necked flask under a nitrogen atmosphere and stirred at 180°C for 18 hours. After the reaction solution was cooled to room temperature, the reaction

solution was filtered, and the filtrate was put in a flask containing 800 ml of water, and stirred for 1 hour. The precipitated solid was collected by filtering, and then dissolved in tetrahydrofuran and extracted with toluene. The organic layer was washed with water, and then concentrated. The concentrate was purified by silica gel column chromatography and thereafter the resulting solid was dried under reduced pressure to yield 7.6 g of an intermediate (C) (yield: 32%).
APCI-TOFMS m/z 667[M+1]$^+$

[C38]

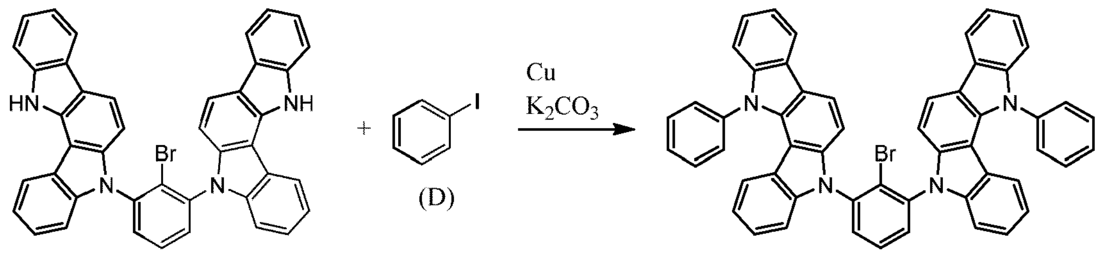

(D)

(C) (E)

Then, 7.6 g of the intermediate (C) obtained above, 200.0 g of a starting material (D), 4.7 g of copper, and 17.3 g of potassium carbonate were put in a three-necked flask under a nitrogen atmosphere and stirred at 190°C for 24 hours. After the reaction solution was cooled to room temperature, the reaction solution was filtered, the resulting solution was concentrated, and the concentrate was purified by silica gel column chromatography. The resulting solid was dried under reduced pressure to yield 7.5 g of an intermediate (E) (yield: 80%).
APCI-TOFMS m/z 819[M+1]$^+$

[C39]

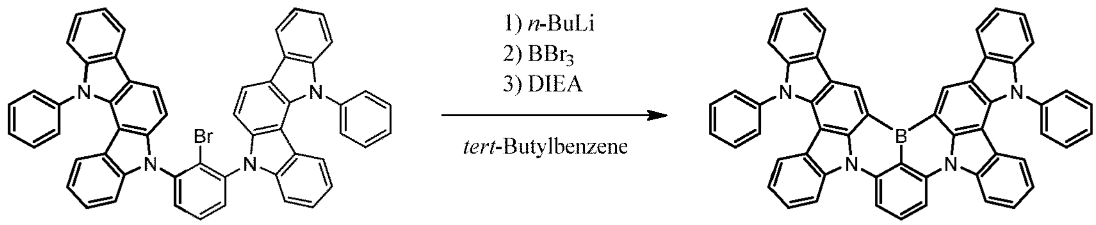


(E) (52)

To a 500-mL Schlenk flask were added 4.1 g of the intermediate (E) obtained above and 250 mL of anhydrous t-butylbenzene. After purging with nitrogen, (1.64 mol/l) 3.3 mL of n-butyllithium was added at -30°C in small amounts, and the resultant was stirred for 1 hour. Subsequently, 0.6 mL of boron tribromide was added at - 30°C in small amounts, and the resultant was stirred at room temperature for 1 hour. Subsequently, 1.7 mL of N,N-diisopropylethylamine was added at 0°C, and the resultant was stirred at 140°C overnight. The reaction solution was cooled to room temperature, and methanol was added in small amounts to take the resulting precipitate by filtering. Thereafter, the precipitate was washed sequentially with methanol, toluene, and hexane in the listed order, and the resulting solid was dried under reduced pressure to yield 1.3 g of a compound (52)

(yield: 35%).
APCI-TOFMS m/z 747[M+1]$^+$

Example 1

Each thin film shown below was laminated on the glass substrate on which an anode made of ITO having a film thickness of 70 nm was formed by a vacuum deposition method at a degree of vacuum of $4.0 \times 10^{-5}$ Pa. First, the previously presented HAT-CN was formed on ITO to a thickness of 10 nm as a hole injection layer, and then HT-1 was formed to a thickness of 25 nm as a hole transport layer. Then, HT-2 was formed to a thickness of 5 nm as an electron blocking layer. Then, BH-1 as the host and the compound (52) in the exemplified compounds previously presented as specific examples of the general formula (1), as the dopant, were co-deposited from different deposition sources to form a light emitting layer

having a thickness of 30 nm. At this time, they were co-deposited under deposition conditions such that the concentration of the compound (52) was 2% by mass. Then, ET-2 was formed to a thickness of 5 nm as a hole blocking layer. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device according to Example 1 was produced.

Comparative Example 1

Each organic EL device was produced in the same manner as in Example 1, except that BD-1 was used as the dopant.

The maximum emission wavelength of the emission spectrum, external quantum efficiency, and lifetime of each organic EL device produced are shown in Table 1. The maximum emission wavelength and the external quantum efficiency were values at a driving current density of 2.5 $mA/cm^2$ and were initial characteristics. The time taken for the luminance to reduce to 70% of the initial luminance when the driving current density was 2.5 $mA/cm^2$ was measured as the lifetime.

[Table 1]

| | **Maximum emission wavelength (nm)** | **External quantum efficiency (%)** | **Lifetime (h)** |
|---|---|---|---|
| **Example 1** | **492** | **21.9** | **230** |
| **Comp. Example 1** | **473** | **19.1** | **43** |

Example 2

Each thin film shown below was laminated on the glass substrate on which an anode made of ITO having a film thickness of 70 nm was formed by a vacuum deposition method at a degree of vacuum of $4.0 \times 10^{-5}$ Pa. First, the previously presented HAT-CN was formed on ITO to a thickness of 10 nm as a hole injection layer, and then HT-1 was formed to a thickness of 25 nm as a hole transport layer. Then, HT-2 was formed to a thickness of 5 nm as an electron blocking layer. Then, BH-1 as the first host, the compound BH-2 as the second host, and the compound (52) as the dopant were co-deposited from different deposition sources to form a light emitting layer having a thickness of 30 nm. At this time, they were co-deposited under deposition conditions such that the concentration of BH-1 was 29% by mass, the concentration of BH-2 was 69% by mass, and the concentration of the compound (52) was 2% by mass. Then, ET-2 was formed to a thickness of 5 nm as a hole blocking layer. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device according to Example 2 was produced.

Comparative Example 2

Each organic EL device was produced in the same manner as in Example 2, except that the dopant was changed to the BD-1.

The maximum emission wavelength of the emission spectrum, external quantum efficiency, and lifetime of each organic EL device produced are shown in Table 2. The maximum emission wavelength and the external quantum efficiency were values at a driving current density of 2.5 $mA/cm^2$ and were initial characteristics. The time taken for the luminance to reduce to 70% of the initial luminance when the driving current density was 2.5 $mA/cm^2$ was measured as the lifetime.

[Table 2]

| | **Maximum emission wavelength (nm)** | **External quantum efficiency (%)** | **Lifetime (h)** |
|---|---|---|---|
| **Example 2** | **491** | **20.0** | **232** |
| **Comp. Example 2** | **473** | **21.7** | **126** |

Example 3

Each thin film shown below was laminated on the glass substrate on which an anode made of ITO having a film

thickness of 70 nm was formed by a vacuum deposition method at a degree of vacuum of $4.0 \times 10^{-5}$ Pa. First, the previously presented HAT-CN was formed on ITO to a thickness of 10 nm as a hole injection layer, and then HT-3 was formed to a thickness of 25 nm as a hole transport layer. Then, HT-4 was formed to a thickness of 5 nm as an electron blocking layer. Then, BH-3 as the host and the compound (52) as the dopant were co-deposited from different deposition sources to form a light emitting layer having a thickness of 30 nm. At this time, they were co-deposited under deposition conditions such that the concentration of the compound (52) was 2% by mass. Then, BH-3 was formed to a thickness of 5 nm as a hole blocking layer. Then, Alq3 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device according to Example 3 was produced.

Comparative Example 3

Each organic EL device was produced in the same manner as in Example 3, except that the dopant was changed to the BD-1.

The maximum emission wavelength of the emission spectrum, external quantum efficiency, and lifetime of each organic EL device produced are shown in Table 3. The maximum emission wavelength and the external quantum efficiency were values at a driving current density of 2.5 mA/cm$^2$ and were initial characteristics. The time taken for the luminance to reduce to 95% of the initial luminance when the driving current density was 10 mA/cm$^2$ was measured as the lifetime.

[Table 3]

| | Maximum emission wavelength (nm) | External quantum efficiency (%) | Lifetime (h) |
|---|---|---|---|
| **Example 3** | **490** | **4.2** | **178** |
| **Comp. Example 3** | **470** | **5.8** | **114** |

From the respective comparisons of the data of Example 1 with Comparative Example 1, Example 2 with Comparative Example 2, and Example 3 with Comparative Example 3 as shown in Tables 1 to 3, the organic EL device including, as a light emitting dopant, the emission material represented by the general formula (1), in which a backbone having a specific 5-ring-fused ring structure was combined with a boron atom, showed excellent results in efficiency and lifetime and showed excellent results particularly in lifetime characteristics. It is considered that the reason for this is as follows: the use of a backbone having a specific 5-ring-fused ring structure expanded conjugation, and improved the stability against oxidation and reduction, and lifetime characteristics.

Synthesis Example 2

[C40]

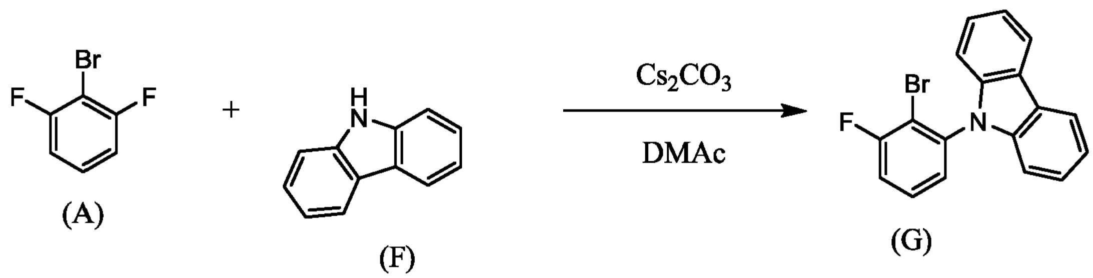


(A) (F) (G)

As shown in the above reaction scheme, 12.0 g of the starting material (A), 10.4 g of a starting material (F), 101.3 g of cesium carbonate, and 300 ml of N,N-dimethylacetamide (DMAc) were put in a three-necked flask under a nitrogen atmosphere and stirred at 90°C for 24 hours. After the reaction solution was cooled to room temperature, the reaction solution was filtered, and the filtrate was put in a flask containing 800 ml of water, and stirred for 1 hour. The precipitated solid was collected by filtering, and then dissolved in tetrahydrofuran and extracted with toluene. The organic layer was washed with water, and then concentrated. The concentrate was purified by silica gel column chromatography and

thereafter the resulting solid was dried under reduced pressure to yield 6.0 g of an intermediate (G) (yield: 27%). APCI-TOFMS m/z 341[M+1]+

[C41]

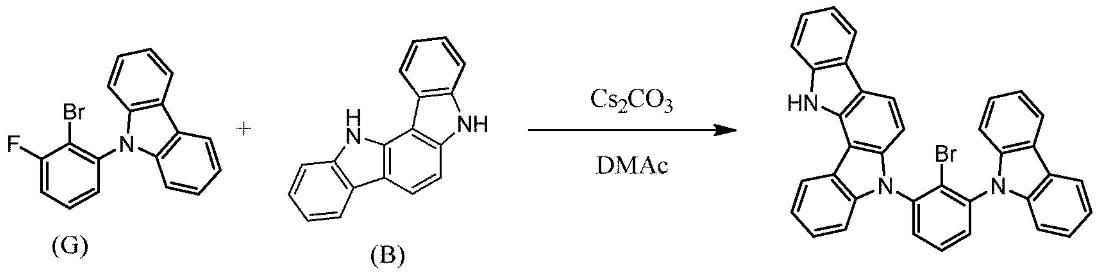


(G) (B) (H)

As shown in the above reaction scheme, 6.0 g of an intermediate (G), 5.0 g of the starting material (B), 28.5 g of cesium carbonate, and 300 ml of N,N-dimethylacetamide (DMAc) were put in a three-necked flask under a nitrogen atmosphere and stirred at 180°C for 5 hours. After the reaction solution was cooled to room temperature, the reaction solution was filtered, and the filtrate was put in a flask containing 800 ml of water, and stirred for 1 hour. The precipitated solid was collected by filtering, and then dissolved in tetrahydrofuran and extracted with toluene. The organic layer was washed with water, and then concentrated. The concentrate was purified by silica gel column chromatography and thereafter the resulting solid was dried under reduced pressure to yield 7.1 g of an intermediate (H) (yield: 72%). APCI-TOFMS m/z 577[M+1]+

[C42]

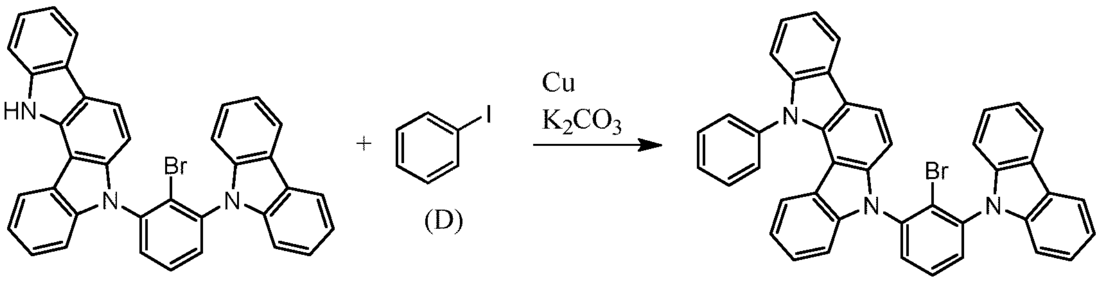


(H) (D) (I)

Then, 7.1 g of the intermediate (H) obtained above, 100.0 g of the starting material (D), 5.1 g of copper, and 18.8 g of potassium carbonate were put in a three-necked flask under a nitrogen atmosphere and stirred at 180°C for 24 hours. After the reaction solution was cooled to room temperature, the reaction solution was filtered, the resulting solution was concentrated, and the concentrate was purified by silica gel column chromatography. The resulting solid was dried under reduced pressure to yield 6.7 g of an intermediate (I)

(yield: 82%).
APCI-TOFMS m/z 653[M+1]+

[C43]

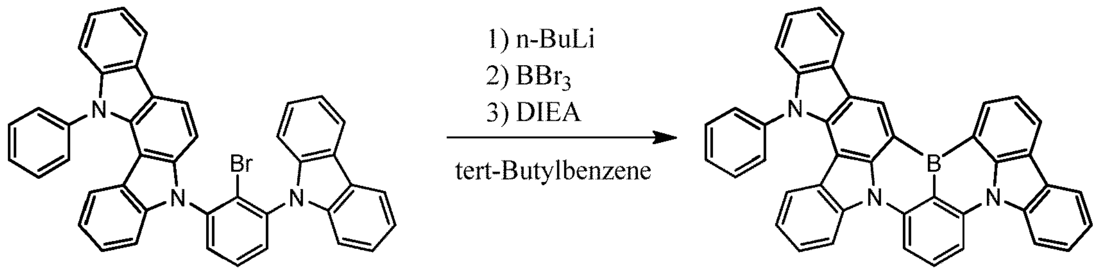


(I) (38)

To a 500-mL Schlenk flask were added 5.0 g of the intermediate (I) obtained above and 250 mL of anhydrous t-butylbenzene. After purging with nitrogen, (1.64 mol/l) 5.2 mL of n-butyllithium was added at -30°C in small amounts, and the resultant was stirred for 2 hours. Subsequently, 0.9 mL of boron tribromide was added at - 30°C in small amounts, and the resultant was stirred at room temperature for 1 hour. Subsequently, 2.7 mL of N,N-diisopropylethylamine (DIEA) was added at 0°C, and the resultant was stirred at 140°C overnight. The reaction solution was cooled to room temperature, and methanol was added in small amounts to take the resulting precipitate by filtering. Thereafter, the precipitate was washed sequentially with methanol, toluene, and hexane in the listed order, and the resulting solid was dried under reduced pressure to yield 1.2 g of a compound (38) (yield: 28%).
APCI-TOFMS m/z $582[M+1]^+$

Synthesis Example 3

[C44]

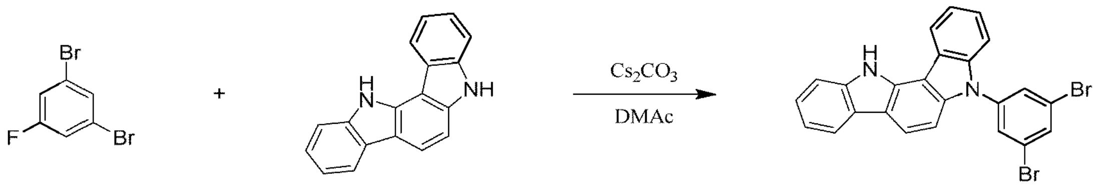


(J) (B) (K)

As shown in the above reaction scheme, 5.0 g of a starting material (J), 5.0 g of the starting material (B), 13.0 g of cesium carbonate, and 40 ml of N,N-dimethylacetamide (DMAc) were put in a three-necked flask under a nitrogen atmosphere and stirred at 160°C for 5 hours. The reaction solution was cooled to room temperature, and then extracted with toluene. The organic layer was washed with water, and then concentrated. The concentrate was subjected to reslurry with methanol, and the resulting solid was dried under reduced pressure to yield 7.8 g of an intermediate (K)

(yield: 81%).
APCI-TOFMS m/z $489[M+1]^+$

[C45]

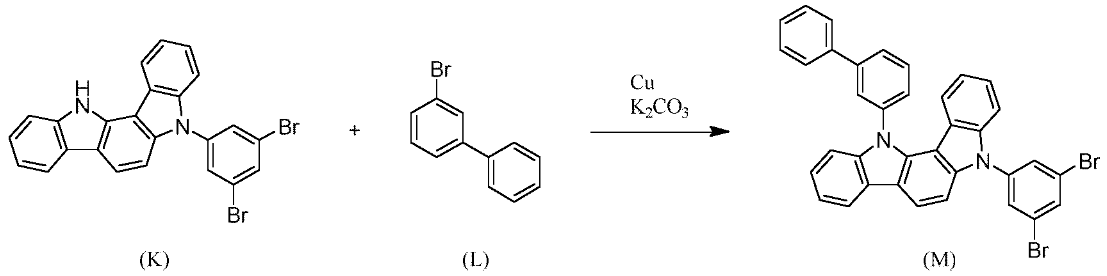


(K) (L) (M)

Then, 4.0 g of the intermediate (K) obtained above, 38.0 g of a starting material (L), 3.1 g of copper, and 12.4 g of potassium carbonate were put in a three-necked flask under a nitrogen atmosphere and stirred at 180°C for 24 hours. After the reaction solution was cooled to room temperature, the reaction solution was filtered, the resulting solution was concentrated, and the concentrate was purified by silica gel column chromatography. The resulting solid was dried under reduced pressure to yield 4.1 g of an intermediate (M) (yield: 79%).
APCI-TOFMS m/z 643[M+1]$^+$

[C46]

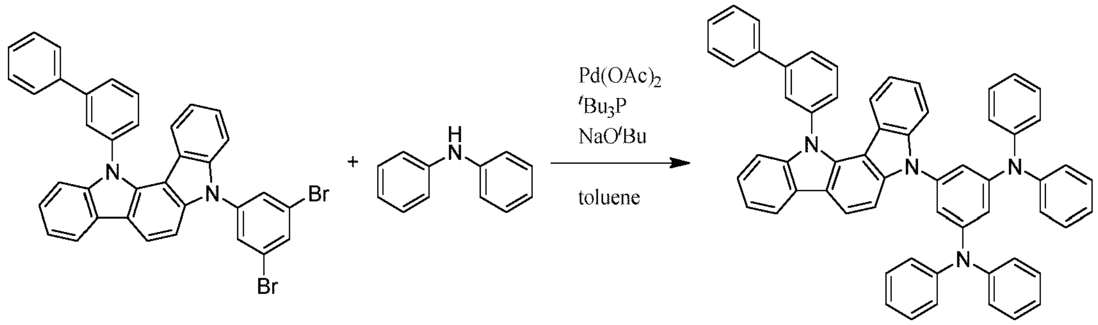


(M) (N) (O)

Then, 4.2 g of the intermediate (M) obtained above, 2.7 g of a starting material (N), 0.2 g of palladium acetate, 0.3 g of tri-t-butylphosphine, 3.1 g of sodium t-butoxide, and 60 ml of toluene were put in a three-necked flask under a nitrogen atmosphere and stirred at 80°C for 1 hour. The reaction solution was cooled to room temperature, and then washed with water and concentrated. The concentrate was purified by silica gel column chromatography. The resulting solid was dissolved in tetrahydrofuran (THF), put in a flask containing methanol, and re-precipitated. The precipitated solid was collected by filtering and dried under reduced pressure to yield 4.2 g of an intermediate (O) (yield: 79%).
APCI-TOFMS m/z 819[M+1]$^+$

[C47]

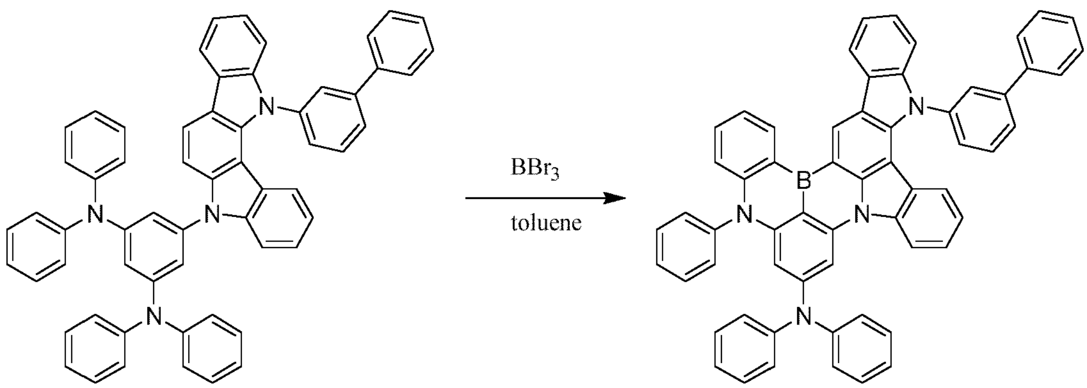


(O) (165)

Then, 2.1 g of the intermediate (O) obtained above, 25 mL of anhydrous toluene, and 1.0 mL of boron tribromide

were put in a three-necked flask under a nitrogen atmosphere and stirred at 125°C for 8 hours. The reaction solution was cooled to room temperature, and water was added thereto. The reaction solution was extracted with dichloromethane, and concentrated. The concentrate was purified by silica gel column chromatography. The resulting solid was dried under reduced pressure to yield 2.0 g of a compound (165)

(yield: 95%).
APCI-TOFMS m/z 827[M+1]$^+$

Synthesis Example 4

[C48]

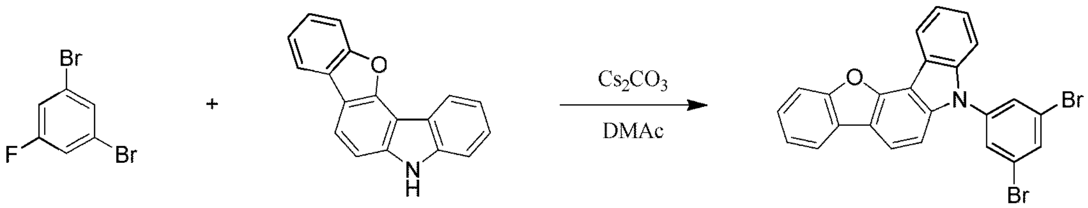


(J) (P) (Q)

As shown in the above reaction scheme, 10.1 g of the starting material (J), 10.0 g of a starting material (P), 31.8 g of cesium carbonate, and 78 ml of N,N-dimethylacetamide (DMAc) were put in a three-necked flask under a nitrogen atmosphere and stirred at 160°C for 4.5 hours. After the reaction solution was cooled to room temperature, the reaction solution was put in a flask containing 500 ml of water, and stirred for 30 minutes. The precipitated solid was collected by filtering, and then subjected to reslurry with 2-propanol and m-xylene in the listed order, and the resulting solid was dried under reduced pressure to yield 17.0 g of an intermediate (Q) (yield: 86%).
APCI-TOFMS m/z 490[M+1]$^+$

[C49]

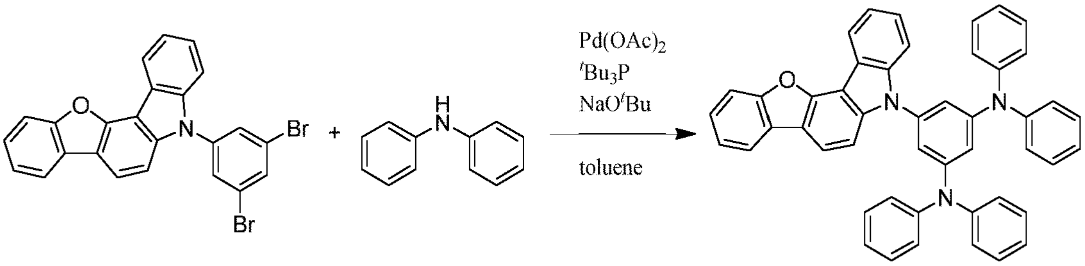


(Q) (N) (R)

Then, 10.0 g of the intermediate (Q) obtained above, 8.3 g of the starting material (N), 0.5 g of palladium acetate, 0.8 g of tri-t-butylphosphine, 9.8 g of sodium t-butoxide, and 200 ml of toluene were put in a three-necked flask under a nitrogen atmosphere and stirred at 80°C for 2 hours. The reaction solution was cooled to room temperature, and then washed with water and concentrated. The concentrate was subjected to reslurry with 2-propanol and tetrahydrofuran (THF) in the listed order, and the resulting solid was dried under reduced pressure to yield 11.5 g of an intermediate (R)

(yield: 85%).
APCI-TOFMS m/z 668[M+1]$^+$

[C50]

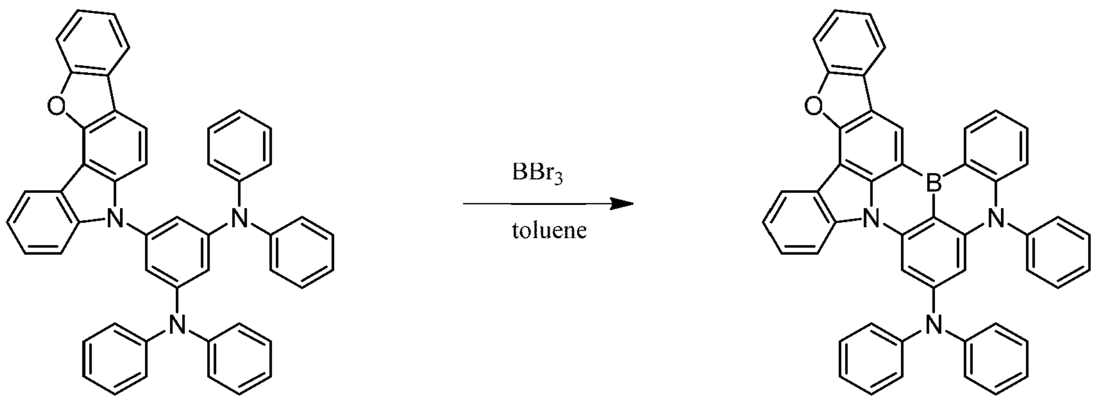


(R) (32)

Then, 3.0 g of the intermediate (R) obtained above, 150 mL of anhydrous toluene, and 1.7 mL of boron tribromide were put in a three-necked flask under a nitrogen atmosphere and stirred at 120°C for 24 hours. The reaction solution was cooled to room temperature, and water was added thereto. The reaction solution was extracted with dichloromethane, and concentrated. The concentrate was purified by silica gel column chromatography. The purified product was heated and dissolved in m-xylene, and crystallized with n-heptane. The resulting solid was dried under reduced pressure to yield 1.6 g of a compound (32) (yield: 53%).
APCI-TOFMS m/z 676$[M+1]^+$

Synthesis Example 5

[C51]

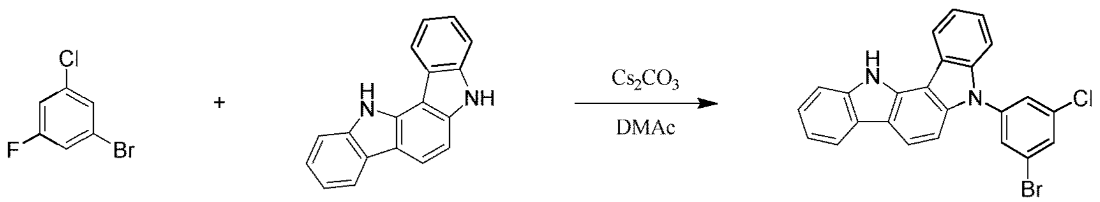


(S) (B) (T)

As shown in the above reaction scheme, 7.7 g of a starting material (S), 7.5 g of the starting material (B), 25.9 g of cesium carbonate, and 60 ml of N,N-dimethylacetamide (DMAc) were put in a three-necked flask under a nitrogen atmosphere and stirred at 160°C for 5 hours. The reaction solution was cooled to room temperature, and then extracted with toluene. The organic layer was washed with water and then concentrated, and the concentrate was purified by silica gel column chromatography. The resulting solid was dissolved in tetrahydrofuran (THF), put in a flask containing methanol, and re-precipitated. The precipitated solid was collected by filtering and dried under reduced pressure to yield 8.8 g of an intermediate (T) (yield: 66%).
APCI-TOFMS m/z 445$[M+1]^+$

[C52]

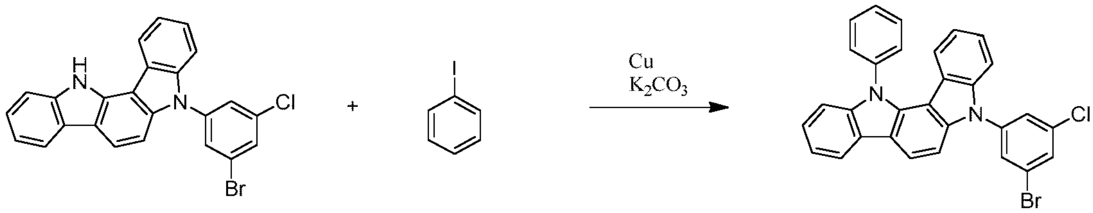


(T) (D) (U)

Then, 8.8 g of the intermediate (T) obtained above, 120.7 g of the starting material (D), 22.6 g of copper, and 30.0 g of potassium carbonate were put in a three-necked flask under a nitrogen atmosphere and stirred at 180°C for 16 hours. After the reaction solution was cooled to room temperature, the reaction solution was filtered, the resulting solution was concentrated, and the concentrate was purified by silica gel column chromatography. The resulting solid was dried under reduced pressure to yield 8.5 g of an intermediate (U)

(yield: 82%).
APCI-TOFMS m/z 521[M+1]$^+$

[C53]

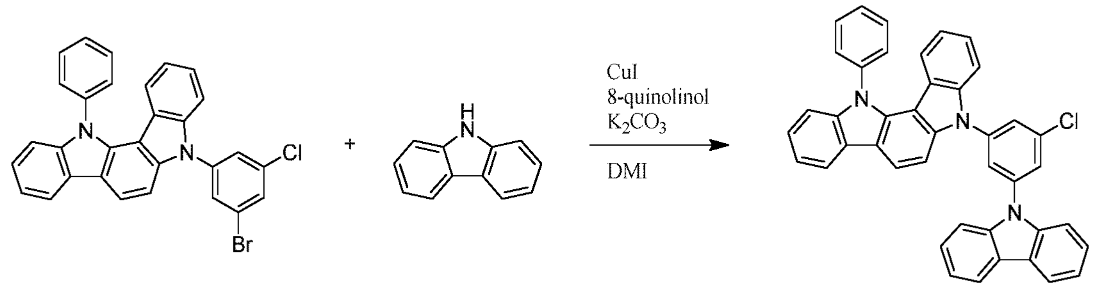


(U) (F) (V)

Then, 7.5 g of the intermediate (U) obtained above, 2.2 g of the starting material (F), 0.2 g of copper iodide, 0.4 g of 8-quinolinol, 3.6 g of potassium carbonate, and 25 ml of 1,3-dimethyl-2-imidazolidinone (DMI) were put in a three-necked flask under a nitrogen atmosphere and stirred at 140°C for 3 hours. After the reaction solution was cooled to room temperature, the reaction solution was put in a flask containing 200 ml of water and stirred for 30 minutes. The precipitated solid was collected by filtering, and then subjected to reslurry with methanol, and the resulting solid was purified by silica gel column chromatography. The purified product was heated and dissolved in toluene, and crystallized with methanol. The resulting solid was dried under reduced pressure to yield 5.0 g of an intermediate (V) (yield: 63%).
APCI-TOFMS m/z 608[M+1]$^+$

[C54]

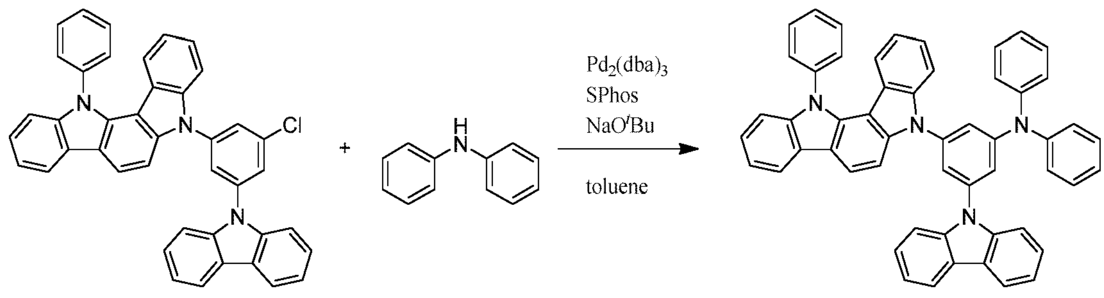


(V) (N) (W)

Then, 4.6 g of the intermediate (V) obtained above, 1.4 g of the starting material (N), 70 mg of tris(dibenzylideneacetone)dipalladium, 86 mg of 2-dicyclohexylphosphino-2',6'-dimethoxybiphenyl (SPhos), 1.4 g of sodium t-butoxide, and 75 ml of toluene were put in a three-necked flask under a nitrogen atmosphere and stirred at 120°C for 1.5 hours. The reaction solution was cooled to room temperature, and then washed with water. The organic layer was filtered with activated white earth, and concentrated. The resulting solid was dissolved in tetrahydrofuran (THF), put in a flask containing methanol, and re-precipitated. The precipitated solid was collected by filtering, and purified by silica gel column chromatography. The resulting solid was dried under reduced pressure to yield 3.0 g of an intermediate (W) (yield: 54%).
APCI-TOFMS m/z 741[M+1]$^+$

[C55]

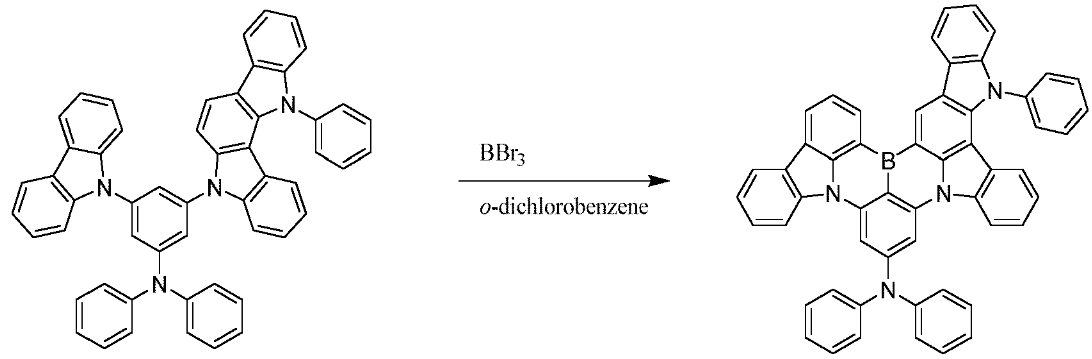


(W) (44)

Then, 3.1 g of the intermediate (W) obtained above, 100 mL of o-dichlorobenzene, and 4.8 mL of boron tribromide were put in a three-necked flask under a nitrogen atmosphere, and stirred at 70°C for 3 hours and stirred at 100°C for 4.5 hours. The reaction solution was cooled to room temperature, and water was added thereto. The reaction solution was extracted with dichloromethane, and the organic layer was put in a flask containing hexane and stirred for 30 minutes. The precipitated solid was collected by filtering, and then subjected to reslurry with acetonitrile, and the resulting solid was dried under reduced pressure to yield 2.6 g of a compound (44) (yield: 83%).
APCI-TOFMS m/z 749$[M+1]^+$

Example 4

Each thin film shown below was laminated on the glass substrate on which an anode made of ITO having a film thickness of 70 nm was formed, by a vacuum deposition method at a degree of vacuum of $4.0 \times 10^{-5}$ Pa. First, the previously presented HAT-CN was formed on ITO to a thickness of 10 nm as a hole injection layer, and then HT-1 was formed to a thickness of 25 nm as a hole transport layer. Then, HT-2 was formed to a thickness of 5 nm as an electron blocking layer. Then, BH-1 as the host and the compound (38) in the exemplified compounds previously presented as specific examples of the general formula (1), as the dopant, were co-deposited from different deposition sources to form a light emitting layer having a thickness of 30 nm. At this time, they were co-deposited under deposition conditions such that the concentration of the compound (38) was 2% by mass. Then, ET-2 was formed to a thickness of 5 nm as a hole blocking layer. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device according to Example 4 was produced.

The maximum emission wavelength of the emission spectrum, external quantum efficiency, and lifetime of each organic EL device produced are shown in Table 4. The maximum emission wavelength and the external quantum efficiency were values at a driving current density of 2.5 mA/cm$^2$ and were initial characteristics. The time taken for the luminance to reduce to 70% of the initial luminance when the driving current density was 2.5 mA/cm$^2$ was measured as the lifetime.

[Table 4]

| | **Maximum emission wavelength (nm)** | **External quantum efficiency (%)** | **Lifetime (h)** |
|---|---|---|---|
| **Example 4** | **487** | **15.3** | **164** |
| **Comp. Example 1** | **473** | **19.1** | **43** |

Example 5

Each thin film shown below was laminated on the glass substrate on which an anode made of ITO having a film thickness of 70 nm was formed by a vacuum deposition method at a degree of vacuum of $4.0 \times 10^{-5}$ Pa. First, the previously presented HAT-CN was formed on ITO to a thickness of 10 nm as a hole injection layer, and then HT-3 was formed to a thickness of 25 nm as a hole transport layer. Then, HT-4 was formed to a thickness of 5 nm as an electron blocking layer. Then, BH-3 as the host and the compound (38) as the dopant were co-deposited from different deposition sources to form a

light emitting layer having a thickness of 30 nm. At this time, they were co-deposited under deposition conditions such that the concentration of the compound (38) was 2% by mass. Then, BH-3 was formed to a thickness of 5 nm as a hole blocking layer. Then, Alq3 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device according to Example 5 was produced.

The maximum emission wavelength of the emission spectrum, external quantum efficiency, and lifetime of each organic EL device produced are shown in Table 5. The maximum emission wavelength and the external quantum efficiency were values at a driving current density of 2.5 mA/$cm^2$ and were initial characteristics. The time taken for the luminance to reduce to 95% of the initial luminance when the driving current density was 10 mA/$cm^2$ was measured as the lifetime.

[Table 5]

| | **Maximum emission wavelength (nm)** | **External quantum efficiency (%)** | **Lifetime (h)** |
|---|---|---|---|
| **Example 5** | **486** | **3.8** | **238** |
| **Comp. Example 3** | **470** | **5.8** | **114** |

Example 6

Each thin film shown below was laminated on the glass substrate on which an anode made of ITO having a film thickness of 70 nm was formed by a vacuum deposition method at a degree of vacuum of $4.0 \times 10^{-5}$ Pa. First, the previously presented HAT-CN was formed on ITO to a thickness of 10 nm as a hole injection layer, and then HT-1 was formed to a thickness of 25 nm as a hole transport layer. Then, HT-2 was formed to a thickness of 5 nm as an electron blocking layer. Then, HT-2 as the first host, the compound ET-2 as the second host, and the compound (165) as the dopant were co-deposited from different deposition sources to form a light emitting layer having a thickness of 30 nm. At this time, they were co-deposited under deposition conditions such that the concentration of HT-2 was 49% by mass, the concentration of ET-2 was 49% by mass, and the concentration of the compound (165) was 2% by mass. Then, ET-2 was formed to a thickness of 5 nm as a hole blocking layer. Then, ET-1 was formed to a thickness of 40 nm as an electron transport layer. Further, lithium fluoride (LiF) was formed on the electron transport layer to a thickness of 1 nm as an electron injection layer. Finally, aluminum (Al) was formed on the electron injection layer to a thickness of 70 nm as a cathode, whereby an organic EL device according to Example 6 was produced.

Example 7

Each organic EL device was produced in the same manner as in Example 6, except that the dopant was changed to the compound (44).

Example 8

Each organic EL device was produced in the same manner as in Example 6, except that the dopant was changed to the compound (32).

Comparative Example 4

Each organic EL device was produced in the same manner as in Example 6, except that the dopant was changed to the BD-2.

The maximum emission wavelength of the emission spectrum, external quantum efficiency, and lifetime of each organic EL device produced are shown in Table 6. The maximum emission wavelength and the external quantum efficiency were values at a driving current density of 2.5 mA/$cm^2$ and were initial characteristics. The time taken for the luminance to reduce to 70% of the initial luminance when the driving current density was 2.5 mA/$cm^2$ was measured as the lifetime.

[Table 6]

| | **Maximum emission wavelength (nm)** | **External quantum efficiency (%)** | **Lifetime (h)** |
|---|---|---|---|
| **Example 6** | **468** | **15.3** | **56** |

(continued)

| | Maximum emission wavelength (nm) | External quantum efficiency (%) | Lifetime (h) |
|---|---|---|---|
| Example 7 | 477 | 16.2 | 89 |
| Example 8 | 468 | 13.8 | 36 |
| Comp. Example 4 | 461 | 9.6 | 27 |

Reference Signs List

1 substrate, 2 anode, 3 hole injection layer, 4 hole transport layer, 5 light emitting layer, 6 electron transport layer, 7 cathode.

## Claims

1. An emission material represented by the following general formula (1):

[C1]

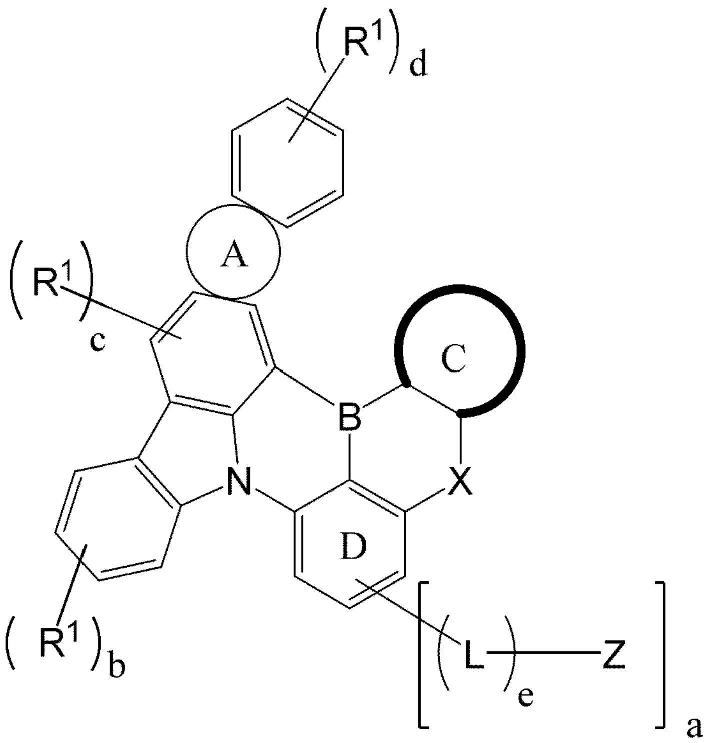

(1)

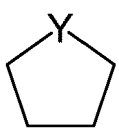

(1a)

wherein B represents a boron atom; a ring A represents a heterocycle fused with an adjacent ring at any position and represented by formula (1a), and a ring C represents a substituted or unsubstituted aromatic hydrocarbon ring having 6 to 30 carbon atoms, a substituted or unsubstituted aromatic heterocyclic ring having 2 to 30 carbon atoms, or a substituted or unsubstituted linked aromatic ring formed by linking 2 to 3 aromatic rings of aromatic groups selected from the aromatic hydrocarbon group and the aromatic heterocyclic group; and a ring D represents a benzene ring;

X represents O, S, or N-$Ar^1$;

$Ar^1$ represents a substituted or unsubstituted aromatic hydrocarbon group having 6 to 30 carbon atoms, a substituted or unsubstituted aromatic heterocyclic group having 2 to 30 carbon atoms, or a substituted or unsubstituted linked aromatic group formed by linking 2 to 4 aromatic rings of aromatic groups selected from the aromatic hydrocarbon group and the aromatic heterocyclic group, and $Ar^1$ is optionally bonded with the ring C or the ring D by a single bond or a linked group to thereby form a ring;
Y represents O, S, or N-$Ar^2$;
$Ar^2$ represents a substituted or unsubstituted aromatic hydrocarbon group having 6 to 30 carbon atoms, a substituted or unsubstituted aromatic heterocyclic group having 2 to 30 carbon atoms, or a substituted or unsubstituted linked aromatic group formed by linking 2 to 4 aromatic rings of aromatic groups selected from the aromatic hydrocarbon group and the aromatic heterocyclic group;
Z independently represents a cyano group, deuterium, an aliphatic hydrocarbon group having 1 to 10 carbon atoms, a substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms; and when Z represents an aliphatic hydrocarbon group having 1 to 10 carbon atoms, a substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms, Z is optionally bonded with the ring D by a single bond to thereby form a ring;
L represents O, S, or $C(R^2)_2$;
$R^2$ independently represents hydrogen, or an aliphatic group having 1 to 8 carbon atoms;
$R^1$ independently represents a cyano group, deuterium, an aliphatic hydrocarbon group having 1 to 10 carbon atoms, a substituted or unsubstituted diarylamino group having 12 to 30 carbon atoms, a substituted or unsubstituted aromatic hydrocarbon group having 6 to 30 carbon atoms, or a substituted or unsubstituted aromatic heterocyclic group having 2 to 30 carbon atoms; and
a represents an integer of 0 to 3, b and d each represent an integer of 0 to 4, and c and e represent 0 or 1.

**2.** The emission material according to claim 1, wherein X in the general formula (1) is represented by N-$Ar^1$.

**3.** The emission material according to claim 1 or 2, wherein Y in the general formula (1a) is represented by N-$Ar^2$.

**4.** The emission material according to any of claims 1 to 3, wherein the ring C in the general formula (1) is represented by a substituted or unsubstituted benzene ring, a substituted or unsubstituted aromatic heterocyclic ring having 2 to 30 carbon atoms, or a substituted or unsubstituted linked aromatic group formed by linking 2 to 3 aromatic rings of aromatic groups selected from the benzene ring and the aromatic heterocyclic group.

**5.** The emission material according to any of claims 1 to 4, wherein the emission material represented by the general formula (1) is represented by the following general formula (2):

[C2]

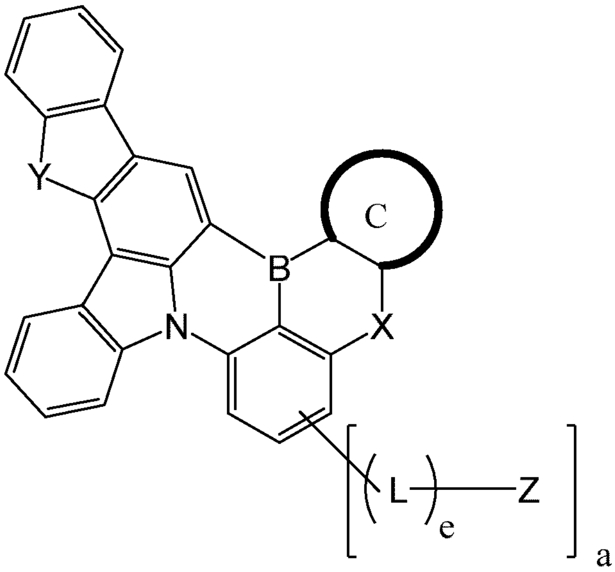

(2)

wherein ring C, X, Y, Z, L, a and e have the same meaning as in the general formula (1).

**6.** An organic electroluminescent device comprising one or more light emitting layers between an anode and a cathode opposite to each other, wherein at least one of the light emitting layers contains the emission material according to any of claims 1 to 5.

**7.** The organic electroluminescent device according to claim 6, wherein the light emitting layer containing the emission material contains a host material.

**8.** The organic electroluminescent device according to any of claim 6 or 7, wherein the host material is a triazine compound.

**9.** The organic electroluminescent device according to any of claim 6 or 7, wherein the host material is an anthracene compound.

**Patentansprüche**

**1.** Ein Emissionsmaterial, dargestellt durch die folgende allgemeine Formel (1):

[C1]

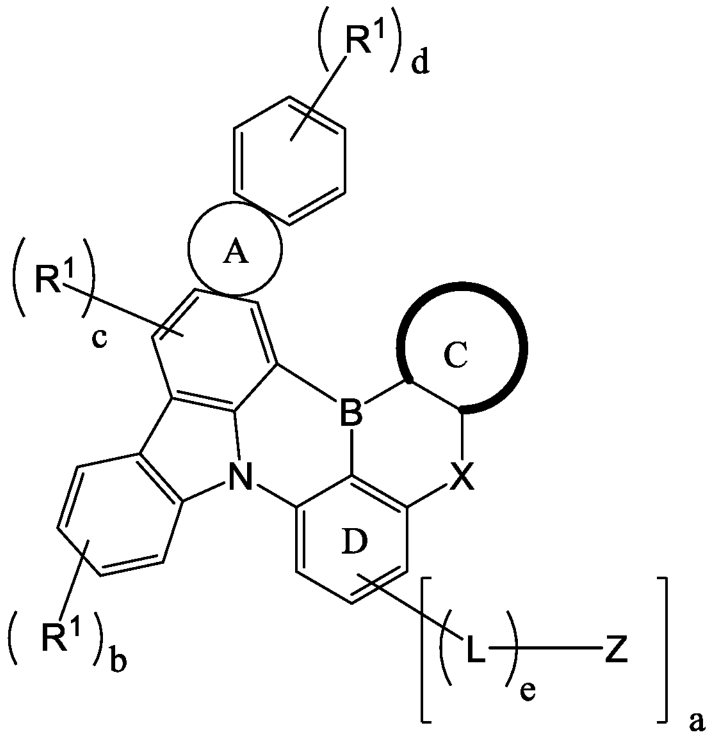

(1)

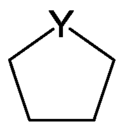

(1a)

wobei B ein Boratom darstellt; ein Ring A einen Heterocyclus darstellt, der mit einem benachbarten Ring an irgendeiner Position kondensiert ist und durch Formel (1a) dargestellt wird, und ein Ring C einen substituierten oder unsubstituierten aromatischen Kohlenwasserstoffring mit 6 bis 30 Kohlenstoffatomen, einen substituierten oder unsubstituierten aromatischen heterocyclischen Ring mit 2 bis 30 Kohlenstoffatomen oder einen substituierten oder unsubstituierten verknüpften aromatischen Ring, der durch Verknüpfen von 2 bis 3 aromatischen Ringen aus aromatischen Gruppen, ausgewählt aus der aromatischen Kohlenwasserstoffgruppe und der aromatischen heterocyclischen Gruppe, gebildet wird, darstellt; und ein Ring D einen Benzolring darstellt;
X gleich O, S oder N-$Ar^1$ darstellt;
$Ar^1$ eine substituierte oder unsubstituierte aromatische Kohlenwasserstoffgruppe mit 6 bis 30 Kohlenstoffatomen, eine substituierte oder unsubstituierte aromatische heterocyclische Gruppe mit 2 bis 30 Kohlenstoffatomen oder eine substituierte oder unsubstituierte verknüpfte aromatische Gruppe, die durch Verknüpfen von 2 bis 4 aromatischen Ringen von aromatischen Gruppen, ausgewählt aus der aromatischen Kohlenwasserstoffgruppe und der aromatischen heterocyclischen Gruppe, gebildet wird, darstellt, und $Ar^1$ gegebenenfalls an den Ring C oder den Ring D durch eine Einfachbindung oder eine Verknüpfungsgruppe gebunden ist, um dadurch einen Ring zu bilden;
Y gleich O, S oder N-$Ar^2$ darstellt;
$Ar^2$ eine substituierte oder unsubstituierte aromatische Kohlenwasserstoffgruppe mit 6 bis 30 Kohlenstoffatomen, eine substituierte oder unsubstituierte aromatische heterocyclische Gruppe mit 2 bis 30 Kohlenstoffatomen oder eine substituierte oder unsubstituierte aromatische Verknüpfungsgruppe, die durch Verknüpfen von 2 bis 4 aromatischen Ringen von aromatischen Gruppen, ausgewählt aus der aromatischen Kohlenwasserstoffgruppe und der aromatischen heterocyclischen Gruppe gebildet wird, darstellt;
Z unabhängig eine Cyanogruppe, Deuterium, eine aliphatische Kohlenwasserstoffgruppe mit 1 bis 10 Kohlenstoffatomen, eine substituierte oder unsubstituierte Diarylaminogruppe mit 12 bis 30 Kohlenstoffatomen, eine substituierte oder unsubstituierte aromatische Kohlenwasserstoffgruppe mit 6 bis 30 Kohlenstoffatomen, oder

eine substituierte oder unsubstituierte aromatische heterocyclische Gruppe mit 2 bis 30 Kohlenstoffatomen darstellt; und wenn Z eine aliphatische Kohlenwasserstoffgruppe mit 1 bis 10 Kohlenstoffatomen, eine substituierte oder unsubstituierte Diarylaminogruppe mit 12 bis 30 Kohlenstoffatomen, eine substituierte oder unsubstituierte aromatische Kohlenwasserstoffgruppe mit 6 bis 30 Kohlenstoffatomen oder eine substituierte oder unsubstituierte aromatische heterocyclische Gruppe mit 2 bis 30 Kohlenstoffatomen darstellt, ist Z gegebenenfalls durch eine Einfachbindung an den Ring D gebunden, um dadurch einen Ring zu bilden;
L gleich O, S oder $C(R^2)_2$ darstellt;
$R^2$ unabhängig Wasserstoff oder eine aliphatische Gruppe mit 1 bis 8 Kohlenstoffatomen darstellt;
$R^1$ unabhängig eine Cyanogruppe, Deuterium, eine aliphatische Kohlenwasserstoffgruppe mit 1 bis 10 Kohlenstoffatomen, eine substituierte oder unsubstituierte Diarylaminogruppe mit 12 bis 30 Kohlenstoffatomen, eine substituierte oder unsubstituierte aromatische Kohlenwasserstoffgruppe mit 6 bis 30 Kohlenstoffatomen oder eine substituierte oder unsubstituierte aromatische heterocyclische Gruppe mit 2 bis 30 Kohlenstoffatomen darstellt; und
a eine ganze Zahl von 0 bis 3 darstellt, b und d jeweils eine ganze Zahl von 0 bis 4 und c und e 0 oder 1 darstellen.

**2.** Das Emissionsmaterial gemäß Anspruch 1, wobei X in der allgemeinen Formel (1) durch N-$Ar^1$ dargestellt wird.

**3.** Das Emissionsmaterial gemäß Anspruch 1 oder 2, wobei Y in der allgemeinen Formel (1a) durch N-$Ar^2$ dargestellt wird.

**4.** Das Emissionsmaterial gemäß einem der Ansprüche 1 bis 3, wobei der Ring C in der allgemeinen Formel (1) durch einen substituierten oder unsubstituierten Benzolring, einen substituierten oder unsubstituierten aromatischen heterocyclischen Ring mit 2 bis 30 Kohlenstoffatomen oder eine substituierte oder unsubstituierte aromatische Verknüpfungsgruppe, die durch Verknüpfen von 2 bis 3 aromatischen Ringen von aromatischen Gruppen, ausgewählt aus dem Benzolring und der aromatischen heterocyclischen Gruppe gebildet wird, dargestellt.

**5.** Das Emissionsmaterial gemäß einem der Ansprüche 1 bis 4, wobei das Emissionsmaterial, dargestellt durch die allgemeine Formel (1), durch die folgende allgemeine Formel (2) dargestellt wird:

[C2]

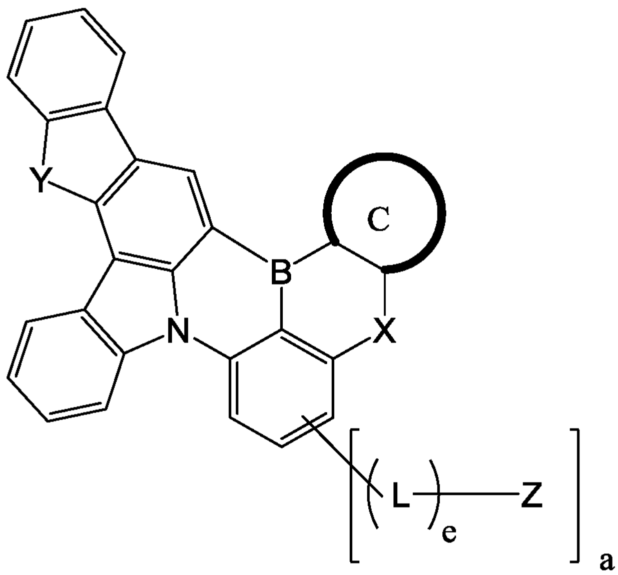

(2)

wobei Ring C, X, Y, Z, L, a und e dieselbe Bedeutung wie in der allgemeinen Formel (1) aufweisen.

**6.** Eine organische Elektrolumineszenzvorrichtung, umfassend eine oder mehrere lichtemittierende Schichten zwischen einer Anode und einer Kathode, welche einander gegenüberliegen, wobei mindestens eine der lichtemittierenden Schichten das Emissionsmaterial gemäß einem der Ansprüche 1 bis 5 enthält.

**7.** Die organische Elektrolumineszenzvorrichtung gemäß Anspruch 6, wobei die lichtemittierende Schicht, die das Emissionsmaterial enthält, ein Wirtsmaterial enthält.

**8.** Die organische Elektrolumineszenzvorrichtung gemäß einem der Ansprüche 6 oder 7, wobei das Wirtsmaterial eine Triazin-Verbindung ist.

**9.** Die organische Elektrolumineszenzvorrichtung gemäß einem der Ansprüche 6 oder 7, wobei das Wirtsmaterial eine Anthracen-Verbindung ist.

## Revendications

**1.** Matériau d'émission représenté par la formule générale (1) suivante :

[C1]

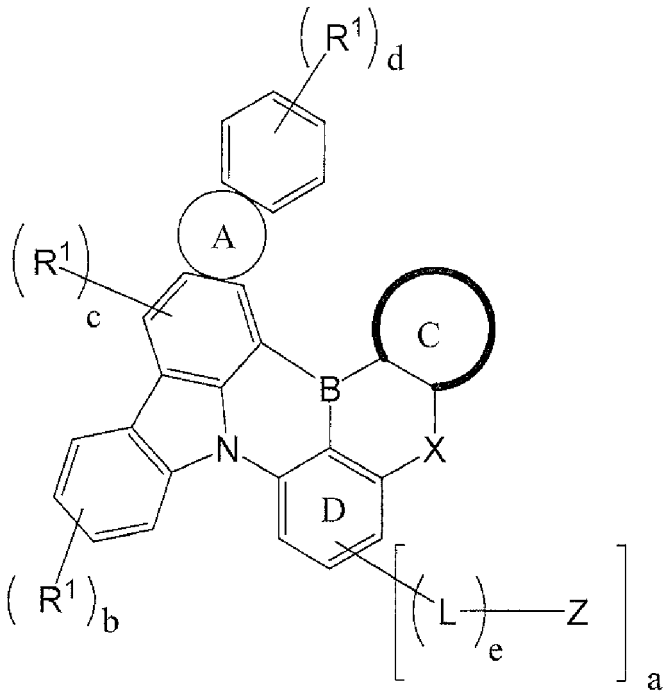

(1)

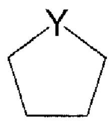

(1a)

dans lequel B représente un atome de bore ; le cycle A représente un hétérocycle condensé à un cycle adjacent en n'importe quelle position et représenté par la formule (1a), et le cycle C représente un cycle hydrocarboné aromatique substitué ou non substitué ayant 6 à 30 atomes de carbone, un hétérocycle aromatique substitué ou non substitué ayant 2 à 30 atomes de carbone, ou un cycle aromatique lié substitué ou non substitué formé par liaison de 2 à 3 cycles aromatiques de groupes aromatiques choisis parmi le groupe hydrocarboné aromatique et le groupe hétérocyclique aromatique ; et le cycle D représente un cycle benzène ;
X représente O, S, ou N-$Ar^1$ ;
$Ar^1$ représente un groupe hydrocarboné aromatique substitué ou non substitué ayant 6 à 30 atomes de carbone, un groupe hétérocyclique aromatique substitué ou non substitué ayant 2 à 30 atomes de carbone, ou un groupe aromatique lié substitué ou non substitué formé par liaison de 2 à 4 cycles aromatiques de groupes aromatiques choisis parmi le groupe hydrocarboné aromatique et le groupe hétérocyclique aromatique, et $Ar^1$ est éventuellement lié au cycle C ou au cycle D par une liaison simple ou un groupe lié pour ainsi former un cycle ;
Y représente O, S, ou N-$Ar^2$ ;
$Ar^2$ représente un groupe hydrocarboné aromatique substitué ou non substitué ayant 6 à 30 atomes de carbone,

un groupe hétérocyclique aromatique substitué ou non substitué ayant 2 à 30 atomes de carbone, ou un groupe aromatique lié substitué ou non substitué formé par liaison de 2 à 4 cycles aromatiques de groupes aromatiques choisis parmi le groupe hydrocarboné aromatique et le groupe hétérocyclique aromatique ;
Z représente indépendamment un groupe cyano, le deutérium, un groupe hydrocarboné aliphatique ayant 1 à 10 atomes de carbone, un groupe diarylamino substitué ou non substitué ayant 12 à 30 atomes de carbone, un groupe hydrocarboné aromatique substitué ou non substitué ayant 6 à 30 atomes de carbone, ou un groupe hétérocyclique aromatique substitué ou non substitué ayant 2 à 30 atomes de carbone ; et quand Z représente un groupe hydrocarboné aliphatique ayant 1 à 10 atomes de carbone, un groupe diarylamino substitué ou non substitué ayant 12 à 30 atomes de carbone, un groupe hydrocarboné aromatique substitué ou non substitué ayant 6 à 30 atomes de carbone, ou un groupe hétérocyclique aromatique substitué ou non substitué ayant 2 à 30 atomes de carbone, Z est éventuellement lié au cycle D par une liaison simple pour ainsi former un cycle ;
L représente O, S, ou $C(R^2)_2$ ;
$R^2$ représente indépendamment l'hydrogène ou un groupe aliphatique ayant 1 à 8 atomes de carbone ;
$R^1$ représente indépendamment un groupe cyano, le deutérium, un groupe hydrocarboné aliphatique ayant 1 à 10 atomes de carbone, un groupe diarylamino substitué ou non substitué ayant 12 à 30 atomes de carbone, un groupe hydrocarboné aromatique substitué ou non substitué ayant 6 à 30 atomes de carbone, ou un groupe hétérocyclique aromatique substitué ou non substitué ayant 2 à 30 atomes de carbone ; et
a représente un entier de 0 à 3, chacun de b et d représente un entier de 0 à 4, et c et e représentent 0 ou 1.

2. Matériau d'émission selon la revendication 1, dans lequel X dans la formule générale (1) est représenté par N-$Ar^1$.

3. Matériau d'émission selon la revendication 1 ou 2, dans lequel Y dans la formule générale (1a) est représenté par N-$Ar^2$.

4. Matériau d'émission selon l'une quelconque des revendications 1 à 3, dans lequel le cycle C dans la formule générale (1) est représenté par un cycle benzène substitué ou non substitué, un hétérocycle aromatique substitué ou non substitué ayant 2 à 30 atomes de carbone, ou un groupe aromatique lié substitué ou non substitué formé par liaison de 2 à 3 cycles aromatiques de groupes aromatiques choisis parmi le cycle benzène et le groupe hétérocyclique aromatique.

5. Matériau d'émission selon l'une quelconque des revendications 1 à 4, lequel matériau d'émission représenté par la formule générale (1) est représenté par la formule générale (2) suivante :

[C2]

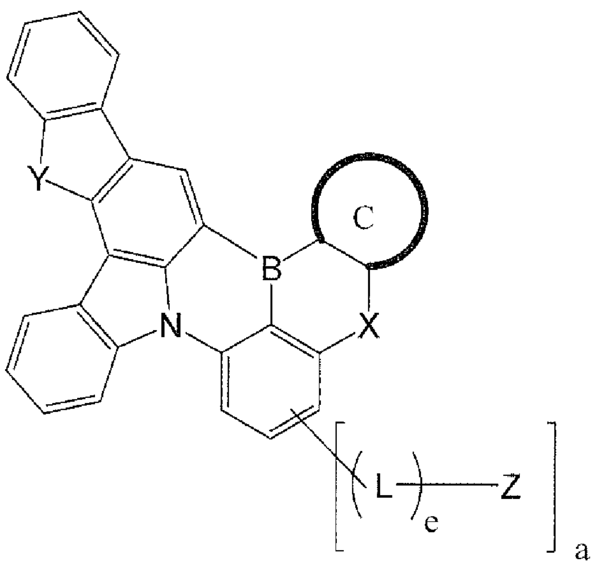

(2)

dans lequel le cycle C, X, Y, Z, L, a et e ont les mêmes significations que dans la formule générale (1).

6. Dispositif électroluminescent organique comprenant une ou plusieurs couches luminescentes entre une anode et une cathode opposées l'une à l'autre, dans lequel au moins une des couches luminescentes contient le matériau

d'émission selon l'une quelconque des revendications 1 à 5.

**7.** Dispositif électroluminescent organique selon la revendication 6, dans lequel la couche luminescente contenant le matériau d'émission contient un matériau hôte.

**8.** Dispositif électroluminescent organique selon l'une quelconque des revendications 6 et 7, dans lequel le matériau hôte est un composé triazine.

**9.** Dispositif électroluminescent organique selon l'une quelconque des revendications 6 et 7, dans lequel le matériau hôte est un composé anthracène.

[Fig. 1]

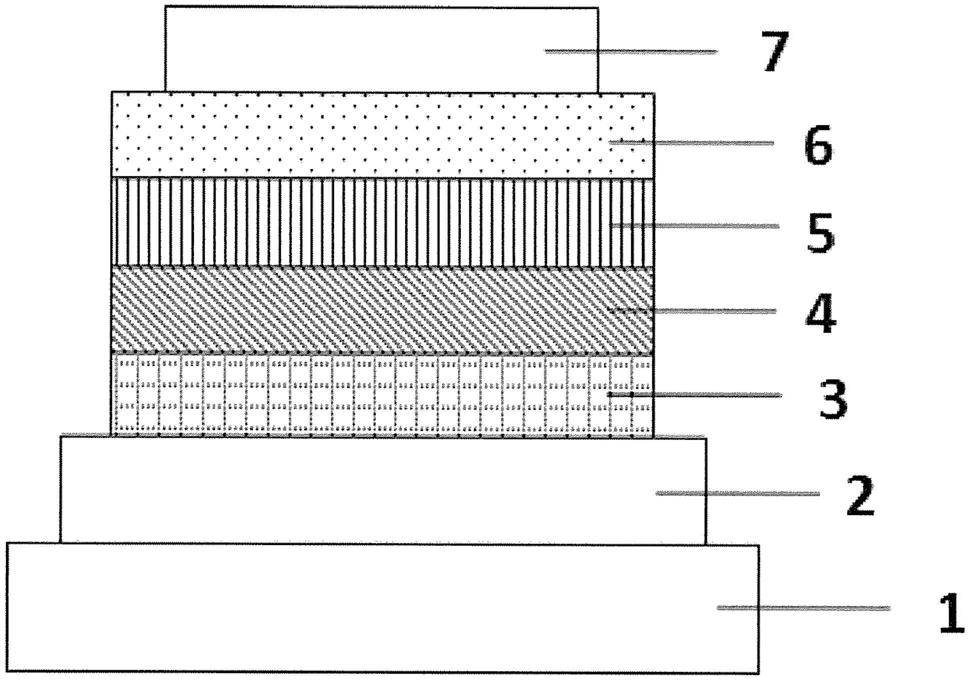

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010134350 A
- WO 2011070963 A
- WO 2015102118 A
- WO 2019240080 A
- US 20200066997 A
- US 2020161552 A